# EUROPEAN PATENT APPLICATION

(11) **EP 4 456 194 A1**
(43) Date of publication of application: **30.10.2024**
(21) Application number: 23742753.9
(22) Date of filing: 10.01.2023
(51) Int. Cl.: H01M 4/505

(54) **CRYSTAL MATERIAL AND PREPARATION METHOD THEREFOR**

(30) Priority: 21.01.2022 CN 202210074769
(71) Applicant: Huawei Technologies Co., Ltd., Shenzhen, Guangdong 518129 (CN)
(72) Inventor: XU, Ruoyu, Shenzhen, Guangdong 518129 (CN); LI, Guangxin, Shenzhen, Guangdong 518129 (CN); XIA, Shengan, Shenzhen, Guangdong 518129 (CN); LEI, Yu, Shenzhen, Guangdong 518129 (CN); WANG, Bo, Shenzhen, Guangdong 518129 (CN)
(74) Representative: Epping - Hermann - Fischer
(86) International application number: PCT/CN2023/071512
(87) International publication number: WO 2023/138438

(57) **Abstract**

Embodiments of this application provide a crystal material and a preparation method thereof. The crystal material includes a secondary particle formed by agglomerating a plurality of monocrystalline grains. There are grain boundaries between the grains. In a cross section of the secondary particle, a ratio L₃/L₄ of a length L₃ of a grain boundary at which a width of an intergranular gap is greater than or equal to 2 nm to a total grain boundary length L₄ is less than or equal to 0.8. Alternatively, the crystal material includes a monocrystalline particle. Each monocrystalline particle includes one monocrystalline grain. Herein, m monocrystalline particles include n first monocrystalline particles. A ratio n/m of n to m is greater than or equal to 0.5, and m ≥ 10. In cross sections of the first monocrystalline particles, a ratio L₁/L₂ of a total length L₁ of all gaps whose widths are greater than or equal to 2 nm to a circumference L₂ of the cross sections is less than or equal to 0.45. The crystal material is obtained by modifying a crystal material primary product in which monocrystalline particles have few defects, a gap at a grain boundary of a secondary particle is small, and bonding between grains is strong. When the crystal material is a battery electrode material or a solid-state electrolyte, electrochemical performance and thermal stability of a battery can be improved.

## Description

This application claims priority to Chinese Patent Application No. 202210074769.2, filed with the China National Intellectual Property Administration on January 21, 2022 and entitled "CRYSTAL MATERIAL AND PREPARATION METHOD THEREOF", which is incorporated herein by reference in its entirety.

### TECHNICAL FIELD

Embodiments of this application relate to the field of crystal material preparation technologies, and in particular, to a crystal material and a preparation method thereof.

### BACKGROUND

With the large-scale popularization of smartphones and electric vehicles, the improvement of battery performance attracts increasing attention in the industry. Currently, a commercial lithium-ion battery mainly includes a positive-electrode material, a negative-electrode material, an electrolyte, and a separator, where the positive-electrode material accounts for 40%. Electrochemical performance of the positive-electrode material directly affects final performance of the battery. One of important determinants of the electrochemical performance of the positive-electrode material is an internal crystal structure of the positive-electrode material.

A current mature ternary positive-electrode material has low initial coulombic efficiency, less than 90%, which greatly affects first-cycle capacity exertion and subsequent capacity expression of the ternary positive-electrode material. Main reasons for low initial coulombic efficiency of a high-nickel ternary positive-electrode material are as follows: Li/Ni disordering occurs in a synthesis process of the ternary positive-electrode material. In a first-cycle charge/discharge process, irreversible oxidation of Ni²⁺ in a lithium layer reduces a first-cycle discharge capacity. In addition, surfaces of particles are prone to surface reconstruction, and migration of transition metal ions on the surfaces induces transformation of a layered structure to a spinel structure and a rock-salt phase structure. The surface rock-salt phase hinders diffusion of lithium ions and slows down a transmission kinetics process of the lithium ions, which causes a great first-cycle capacity loss. In a polycrystalline material, there are grain boundaries between grains due to different orientations of the grains, and a large quantity of rock-salt phase structures converge at the grain boundaries, which greatly hinders transmission of lithium ions. In addition, as there is a large gap and a weak bonding force at a grain boundary, in a battery charge/discharge cycle, a crack of a positive-electrode material particle extends from a grain boundary of a grain, and then an electrolyte seeps into the grain boundary and the crack, inducing an interface side reaction. Consequently, cycle stability of the material is reduced.

Therefore, it is necessary to provide a positive-electrode material and a preparation method thereof. A grain boundary of the positive-electrode material is modified, to improve a diffusion kinetics process of lithium ions between primary grains, strengthen grain boundary bonding, and suppress electrolyte seeping and crack extension, thereby finally improving initial coulombic efficiency and cycle stability of the positive-electrode material.

### SUMMARY

In view of this, embodiments of this application provide a crystal material and a preparation method thereof. The crystal material is obtained by modifying a crystal material primary product in which monocrystalline particles have few defects, a gap at a grain boundary of a secondary particle is small, and bonding between grains is strong. When the crystal material is a battery electrode material or a solid-state electrolyte, electrochemical performance of a battery can be improved, to resolve, to some extent, a problem that a gap at a grain boundary of an existing crystal material is large and is consequently not conducive to improving electrochemical performance of the material.

Specifically, according to a first aspect of embodiments of this application, a crystal material is provided. The crystal material includes a secondary particle formed by agglomerating a plurality of monocrystalline grains, there are grain boundaries between the plurality of monocrystalline grains, and in a cross section of the secondary particle, a ratio L₃/L₄ of a grain boundary length L₃ of a grain boundary at which a width of an intergranular gap is greater than or equal to 2 nm to a total grain boundary length L₄ is less than or equal to 0.8; or
the crystal material includes a monocrystalline particle, each monocrystalline particle includes one monocrystalline grain, m monocrystalline particles include n first monocrystalline particles, a ratio n/m of n to m is greater than or equal to 0.5, and m ≥ 10; and in cross sections of the first monocrystalline particles, a ratio L₁/L₂ of a total length L₁ of all gaps whose widths are greater than or equal to 2 nm to a circumference L₂ of the cross sections is less than or equal to 0.45.

The crystal material in embodiments of this application is obtained by modifying a crystal material primary product. Large-gap defects are less distributed in the monocrystalline particle bulk phase, so that a material yield rate is high. The intergranular gap in the secondary particle is small, so that bonding between the grains is strong. The crystal material in embodiments of this application has excellent electrochemical performance and thermal stability, and has the electrochemical performance and thermal stability significantly improved compared with the crystal material primary product before modification.

In an implementation of this application, in the cross section of the secondary particle, the ratio L₃/L₄ of the grain boundary length L₃ of the grain boundary at which the width of the intergranular gap is greater than or equal to 2 nm to the total grain boundary length L₄ is less than or equal to 0.5.

In an implementation of this application, in the cross section of the secondary particle, a ratio L₅/L₄ of a grain boundary length L₅ of a grain boundary at which a width of an intergranular gap is greater than or equal to 1.5 nm to the total grain boundary length L₄ is less than or equal to 0.8.

In an implementation of this application, in the cross section of the secondary particle, a ratio L₆/L₄ of a grain boundary length L₆ of a grain boundary at which a width of an intergranular gap is greater than or equal to 1 nm to the total grain boundary length L₄ is less than or equal to 0.8.

In an implementation of this application, in the cross section of the secondary particle, a ratio L₇/L₄ of a grain boundary length L₇ of a grain boundary at which a width of an intergranular gap is greater than or equal to 0.5 nm to the total grain boundary length L₄ is less than or equal to 0.8.

In the crystal material in this application, for the secondary particle, grain boundary fusion, that is, intergranular gap reduction, can effectively improve a diffusion kinetics process of ions in the crystal material particle, improve initial coulombic efficiency of the material, and suppress crack extension, thereby improving structural stability of the crystal material, suppressing lattice oxygen release, and improving thermal stability of the material. Smaller ratios L₃/L₄, L₅/L₄, L₆/L₄, and L₇/L₄ indicate a higher grain boundary fusion degree of the entire secondary particle.

In the crystal material in this application, for the monocrystalline particle, a crack defect inside the particle is reduced, so that an overall yield of the material can be improved, thereby improving structural stability and electrochemical performance of the material. A larger ratio n/m and a smaller ratio L₁/L₂ indicate a higher yield of a monocrystalline particle product. In some implementations of this application, the ratio n/m of n to m is greater than or equal to 0.7. In some implementations of this application, in the cross sections of the first monocrystalline particles, the ratio L₁/L₂ of the total length L₁ of all gaps whose widths are greater than or equal to 2 nm to the circumference L₂ of the cross sections is less than or equal to 0.2.

In an implementation of this application, in the cross section of the secondary particle, a continuous grain boundary length of a grain boundary at which a width of an intergranular gap is less than 2 nm is 10 nm to 1000 nm.

In some implementations of this application, in the secondary particle, there is no impurity element, different from each element in adjacent monocrystalline grains, at a grain boundary between the adjacent monocrystalline grains. In this way, a crystal structure of the crystal material primary product can be better repaired, and uniformity and consistency inside the crystal material can be maintained.

In some embodiments, the grain boundary between the adjacent monocrystalline grains is a crystal structure obtained through epitaxial growth along atomic arrangements of the adjacent monocrystalline grains.

In some other embodiments, the grain boundary between the adjacent monocrystalline grains is filled with a first metal salt, and the first metal salt is an alkali metal salt or an alkaline earth metal salt that has a same alkali metal or alkaline earth metal element as the adjacent monocrystalline grains.

In some other implementations of this application, in the secondary particle, there is an impurity element, different from each element in adjacent monocrystalline grains, at a grain boundary between the adjacent monocrystalline grains.

In some embodiments, the grain boundary between the adjacent monocrystalline grains is filled with a second metal salt, and the second metal salt is an alkali metal salt or an alkaline earth metal salt that has a same alkali metal or alkaline earth metal element as the adjacent monocrystalline grains.

In an implementation of this application, a thickness of a phase change layer on a surface of the monocrystalline grain is less than or equal to 1 nm. A smaller thickness of the phase change layer indicates that the surface of the monocrystalline particle is repaired, and consistency of the overall crystal structure of the particle is higher, which is more conducive to improving performance of the crystal material and improving a transmission kinetics process of ions.

In an implementation of this application, in the secondary particle, crystal face orientations of two adjacent monocrystalline grains are random.

In an implementation of this application, in the secondary particle, at least some adjacent monocrystalline grains are fused at a grain boundary to form a grain boundary-modified agglomerate, each grain boundary-modified agglomerate includes two or more monocrystalline grains, and in the grain boundary-modified agglomerate, a width of an intergranular gap at a grain boundary at which monocrystalline grains are fused is less than 2 nm.

In an implementation of this application, fusion of the at least some adjacent monocrystalline grains at the grain boundary is atomic-level epitaxial junction fusion, and the width of the intergranular gap at the grain boundary is less than or equal to 0.5 nm.

In an implementation of this application, the monocrystalline grain is a battery electrode material or a solid-state electrolyte.

In an implementation of this application, the battery electrode material includes a lithium-ion battery electrode material, a sodium-ion battery electrode material, a potassium-ion battery electrode material, or a magnesium-ion battery electrode material.

In an implementation of this application, the lithium-ion battery electrode material includes a lithium-containing composite oxide; the sodium-ion battery electrode material includes one or more of a sodium-containing composite oxide, Prussian blue, and Prussian white; the potassium-ion battery electrode material includes a potassium-containing composite oxide; and the magnesium-ion battery electrode material includes a magnesium-containing composite oxide. The lithium-containing composite oxide includes one or more of a lithium-cobalt oxide (for example, lithium cobaltate LiCoO₂), a lithium-nickel oxide (for example, lithium nickelate LiNiO₂), a lithium-manganese oxide (for example, lithium manganate LiMnO₂ or lithium permanganate), a lithium-titanium oxide (for example, lithium titanate), a lithium-iron-phosphorus oxide (for example, lithium iron phosphate), a lithium-nickel-cobalt oxide (for example, lithium nickel cobaltate LiNiₐCo₁₋ₐO₂), a lithium-nickel-manganese oxide (for example, lithium nickel manganate LiNiₐMn₁₋ₐO₂), and a nickel-cobalt multi-element oxide (for example, lithium nickel cobalt manganate LiNiₐCo_{b}Mn_{1-a-b}O₂, lithium nickel cobalt aluminate LiNiₐCo_{b}Al_{1-a-b}O₂, or lithium nickel cobalt manganese aluminate LiNiₐCo_{b}Mn_{c}Al_{1-a-b-c}O₂), where 0 < a < 1, 0 < b < 1, 0 < c < 1, 0 < 1-a-b < 1, and 0 < 1-a-b-c < 1.

In an implementation of this application, the solid-state electrolyte includes one or more of an oxide-type solid-state electrolyte, a sulfide-type solid-state electrolyte, and a halogenated solid-state electrolyte.

According to a second aspect of embodiments of this application, a crystal material is provided. The crystal material includes a monocrystalline particle, and each monocrystalline particle includes one monocrystalline grain, or the crystal material includes a secondary particle formed by agglomerating a plurality of monocrystalline grains, where a thickness of a phase change layer on a surface of the monocrystalline grain is less than or equal to 1 nm.

In an implementation of this application, m monocrystalline particles include n first monocrystalline particles, a ratio n/m of n to m is greater than or equal to 0.5, and m ≥ 10; and in cross sections of the first monocrystalline particles, a ratio L₁/L₂ of a total length L₁ of all gaps whose widths are greater than or equal to 2 nm to a circumference L₂ of the cross sections is less than or equal to 0.45.

In an implementation of this application, there are grain boundaries between the plurality of monocrystalline grains, and in a cross section of the secondary particle, a ratio L₃/L₄ of a grain boundary length L₃ of a grain boundary at which a width of an intergranular gap is greater than or equal to 2 nm to a total grain boundary length L₄ is less than or equal to 0.8.

In an implementation of this application, in the cross section of the secondary particle, a continuous grain boundary length of a grain boundary at which a width of an intergranular gap is less than 2 nm is 10 nm to 1000 nm.

In some implementations of this application, in the secondary particle, there is no impurity element, different from each element in adjacent monocrystalline grains, at a grain boundary between the adjacent monocrystalline grains. In this way, a crystal structure of the crystal material primary product can be better repaired, and uniformity and consistency inside the crystal material can be maintained.

In some embodiments, the grain boundary between the adjacent monocrystalline grains is a crystal structure obtained through epitaxial growth along atomic arrangements of the adjacent monocrystalline grains.

In some other embodiments, the grain boundary between the adjacent monocrystalline grains is filled with a first metal salt, and the first metal salt is an alkali metal salt or an alkaline earth metal salt that has a same alkali metal or alkaline earth metal element as the adjacent monocrystalline grains.

In some other implementations of this application, in the secondary particle, there is an impurity element, different from each element in adjacent monocrystalline grains, at a grain boundary between the adjacent monocrystalline grains.

In some embodiments, the grain boundary between the adjacent monocrystalline grains is filled with a second metal salt, and the second metal salt is an alkali metal salt or an alkaline earth metal salt that has a same alkali metal or alkaline earth metal element as the adjacent monocrystalline grains.

In an implementation of this application, a thickness of a phase change layer on a surface of the monocrystalline grain is less than or equal to 1 nm. A smaller thickness of the phase change layer indicates that the surface of the monocrystalline particle is repaired, and consistency of the overall crystal structure of the particle is higher, which is more conducive to improving performance of the crystal material and improving a transmission kinetics process of ions.

In an implementation of this application, in the secondary particle, crystal face orientations of two adjacent monocrystalline grains are random.

In an implementation of this application, in the secondary particle, at least some adjacent monocrystalline grains are fused at a grain boundary to form a grain boundary-modified agglomerate, each grain boundary-modified agglomerate includes two or more monocrystalline grains, and in the grain boundary-modified agglomerate, a width of an intergranular gap at a grain boundary at which monocrystalline grains are fused is less than 2 nm.

In an implementation of this application, fusion of the at least some adjacent monocrystalline grains at the grain boundary is atomic-level epitaxial junction fusion, and the width of the intergranular gap at the grain boundary is less than or equal to 0.5 nm.

In an implementation of this application, the monocrystalline grain is a battery electrode material or a solid-state electrolyte.

According to a third aspect of embodiments of this application, a method for preparing a crystal material is provided, including the following steps:
mixing a to-be-modified crystal material primary product with a metal salt to obtain a mixture, heating the mixture to melt the metal salt, and then cooling the mixture, where a metal element of the metal salt is an alkali metal element or an alkaline earth metal element that is the same as that of the crystal material primary product; and
collecting the cooled mixture to obtain the crystal material; or introducing oxygen or inert gas into the cooled mixture, and heating to 400°C to 900°C and keeping at the same temperature for 1 hour to 12 hours, to obtain the crystal material.

In an implementation of this application, a molar mass of the metal salt is 0.1% to 20% of a molar mass of the crystal material primary product.

In an implementation of this application, the alkali metal element includes one or more of a lithium element, a sodium element, and a potassium element; the alkaline earth metal element includes a magnesium element; when the crystal material primary product includes the lithium element, the metal salt includes a lithium salt; when the crystal material primary product includes the sodium element, the metal salt includes a sodium salt; when the crystal material primary product includes the potassium element, the metal salt includes a potassium salt; and when the crystal material primary product includes the magnesium element, the metal salt includes a magnesium salt.

In an implementation of this application, the lithium salt includes one or more of lithium nitrate, lithium hydroxide, lithium carbonate, and a lithium supplement; and the sodium salt includes one or more of sodium nitrate, sodium hydroxide, sodium carbonate, and a sodium supplement.

According to a fourth aspect of embodiments of this application, a battery is provided. The battery includes the crystal material according to the first aspect of embodiments of this application, or the crystal material according to the second aspect of embodiments of this application, or the crystal material obtained by using the preparation method according to the third aspect of embodiments of this application.

An embodiment of this application further provides an electronic device. The electronic device includes the battery according to the fourth aspect of embodiments of this application.

An embodiment of this application further provides an energy storage system. The energy storage system includes the battery according to the fourth aspect of embodiments of this application.

### BRIEF DESCRIPTION OF DRAWINGS

FIG. 1A is a diagram of a stacked structure of grains of an existing polycrystalline positive-electrode material 10;
FIG. 1B is a diagram of a structure of a grain boundary of an existing polycrystalline positive-electrode material 10;
FIG. 1C is a spherical aberration electron microscope (AC-TEM) graph of a grain boundary between grains of an existing polycrystalline positive-electrode material 10;
FIG. 2 is a diagram of a structure of a crystal material 100 according to an embodiment of this application;
FIG. 3 is a diagram of a structure of a crystal material 100 according to another embodiment of this application;
FIG. 4 is a diagram of a partial structure of a particle of a crystal material 100 according to another embodiment of this application;
FIG. 5 is a diagram of a structure of a grain boundary in a crystal material 100 according to an embodiment of this application;
FIG. 6A, FIG. 6B, and FIG. 6C are spherical aberration electron microscope graphs of grain boundaries between grains of a crystal material 100 according to an embodiment of this application;
FIG. 7 is a diagram of crystal-face atomic-level epitaxial junction fusion of adjacent grains in a crystal material 100 according to this application;
FIG. 8 is an electron microscope graph of a phase change layer on a surface of a grain of a crystal material before modification according to an embodiment of this application;
FIG. 9 is an electron microscope graph of a phase change layer on a surface of a grain of a crystal material according to an embodiment of this application;
FIG. 10 is a diagram of a structure of a battery 30 according to an embodiment of this application;
FIG. 11 is a diagram of a structure of an electronic device 40 according to an embodiment of this application;
FIG. 12 is a diagram of a structure of an energy storage system 50 according to an embodiment of this application;
FIG. 13 is a SEM (scanning electron microscope) graph of a cross section of a grain boundary-modified polycrystalline positive-electrode material LiNi_{0.82}Co_{0.12}Mn_{0.06}O₂ according to Embodiment 1 of this application;
FIG. 14 is a SEM graph of a cross section of an unmodified polycrystalline positive-electrode material LiNi_{0.82}Co_{0.12}Mn_{0.06}O₂ according to Comparative Example 1;
FIG. 15 is an electron microscope graph of atomic-level epitaxial junction fusion at a grain boundary between primary grains of a grain boundary-modified polycrystalline positive-electrode material LiNi_{0.82}Co_{0.12}Mn_{0.06}O₂ according to Embodiment 1 of this application;
FIG. 16 shows differential scanning calorimetry curves of positive-electrode material samples in Embodiment 1 and Comparative Example 1;
FIG. 17 shows initial charge/discharge curves of batteries in Embodiment 1 and Comparative Example 1;
FIG. 18 shows differential capacity curves of batteries in Embodiment 1 and Comparative Example 1; and
FIG. 19 shows cycle performance curves of batteries in Embodiment 1 and Comparative Example 1 according to this application.

### DESCRIPTION OF EMBODIMENTS

The following describes embodiments of this application with reference to accompanying drawings in embodiments of this application.

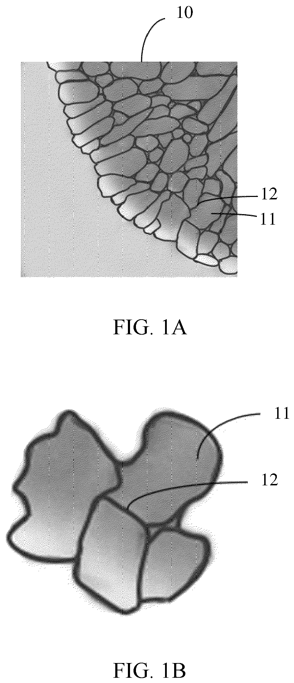

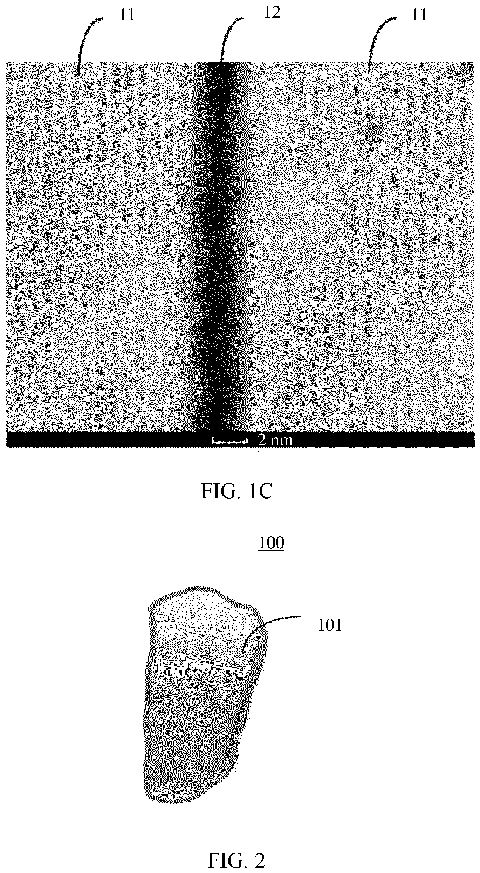

FIG. 1A is a diagram of a stacked structure of grains of an existing polycrystalline positive-electrode material 10. FIG. 1B is a diagram of a structure of a grain boundary of an existing polycrystalline positive-electrode material 10. FIG. 1C is a spherical aberration electron microscope graph of a grain boundary between grains of an existing polycrystalline positive-electrode material 10. The polycrystalline positive-electrode material 10 is usually formed by stacking and agglomerating a plurality of primary grains 11. A large quantity of grain boundaries 12 are distributed inside the polycrystalline positive-electrode material 10. A grain boundary is an interface between grains, and may exist inside a primary particle or may exist inside a secondary particle. For the polycrystalline positive-electrode material, at the grain boundary, a phase change occurs in a crystal structure in a battery charge/discharge process due to migration and transition of cations (for example, transition metal cobalt ions). As a result, a transmission kinetics process of ions at the grain boundary deteriorates. For example, in a lithium-ion battery, a phase change blocks transmission of lithium ions at a grain boundary, and consequently reduces a first-cycle discharge capacity of the material. In addition, in a battery cycle process, a volume strain caused by ion deintercalation accumulates at the grain boundary, resulting in an intergranular crack. As an intergranular gap at the grain boundary of the existing polycrystalline material is large, as shown in FIG. 1A, FIG. 1B, and FIG. 1C, there is a clear gap at the grain boundary 12, the intergranular crack is likely to extend along the grain boundary between the grains, and then an electrolyte seeps into the grain boundary and the crack, inducing an interface side reaction. Consequently, cycle stability of the material is reduced. For a monocrystalline material, as high-temperature sintering in a synthesis process causes a phase change and a defect near the surface of the material, a microcrack may also occur inside the bulk phase, which also slows down a diffusion kinetics process of ions, consequently affecting electrochemical performance of the material. To improve electrochemical performance of the existing monocrystalline or polycrystalline positive-electrode material, this application provides a crystal material and a preparation method thereof. The crystal material may be a battery electrode material (a positive-electrode material or a negative-electrode material) or a solid-state electrolyte. The crystal material is obtained through grain boundary modification or defect repairing, which has a good diffusion kinetics process of ions and good grain boundary stability, and is not easy to crack. Therefore, electrochemical performance (including ionic conductivity, cycle stability, and the like) and thermal stability of the crystal material are greatly improved.

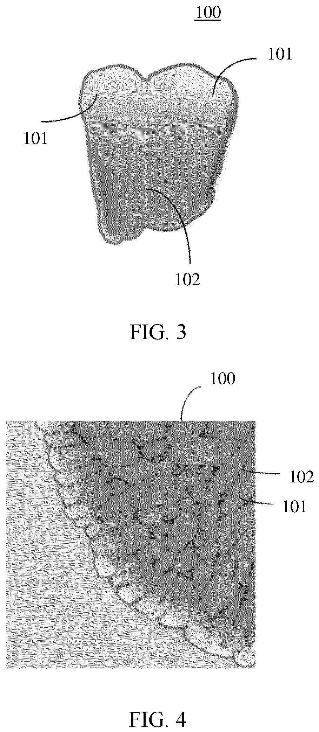

FIG. 2 is a diagram of a structure of a crystal material 100 according to an embodiment of this application. FIG. 3 is a diagram of a structure of a crystal material 100 according to another embodiment of this application. FIG. 4 is a diagram of a partial structure of a particle of a crystal material 100 according to another embodiment of this application. The crystal material 100 provided in embodiments of this application includes one or more stacked monocrystalline grains 101. The crystal material 100 may be a monocrystalline particle, or may be a mono-like crystalline particle or a polycrystalline particle. The monocrystalline particle includes only one monocrystalline grain 101, that is, is formed by one monocrystalline grain 101. The mono-like crystalline particle or the polycrystalline particle is a secondary particle formed by stacking and agglomerating a plurality of (two or more) monocrystalline grains 101. In other words, when the crystal material 100 includes a plurality of stacked and agglomerated monocrystalline grains 101, the crystal material 100 may be a mono-like crystalline particle, or may be a polycrystalline particle. The crystal material 100 in embodiments of this application is obtained by modifying a crystal material primary product formed by crystallization.

Refer to FIG. 2. In some implementations of this application, the crystal material 100 is a monocrystalline particle, and the crystal material 100 includes one monocrystalline grain 101. In this implementation, the monocrystalline particle has a high yield, m monocrystalline particles include n first monocrystalline particles, and a ratio n/m of n to m is greater than or equal to 0.5, that is, in the m monocrystalline particles, a quantity of the first monocrystalline particles is greater than or equal to 50%, where m ≥ 10. In cross sections of the first monocrystalline particles, a ratio L₁/L₂ of a total length L₁ of all gaps whose widths are greater than or equal to 2 nm to a circumference L₂ of the cross sections is less than or equal to 0.45, that is, the first monocrystalline particles are monocrystalline particles whose ratio L₁/L₂ of the total length L₁ of all gaps whose widths are greater than or equal to 2 nm in the cross sections to the circumference L₂ of the cross sections is less than or equal to 0.45. In this implementation, the crystal material 100 may be of various regular or irregular shapes, and the monocrystalline particle is usually of an irregular shape. The monocrystalline particle in this embodiment of this application is obtained by modifying a monocrystalline particle primary product. After the modification, microcracks and defects inside and near a surface of the monocrystalline particle bulk phase can be repaired to some extent, and crystal structures on both sides of a repaired gap are the same. In this embodiment of this application, the gap in the monocrystalline particle bulk phase is repaired after the modification, and a surface or internal gap with a large width is less distributed. Therefore, the monocrystalline particle has excellent electrochemical performance and thermal stability. In some embodiments of this application, in the cross sections of the first monocrystalline particles, the ratio L₁/L₂ of the total length L₁ of all gaps whose widths are greater than or equal to 2 nm to the circumference L₂ of the cross sections is less than or equal to 0.4. In some embodiments of this application, in the cross sections of the first monocrystalline particles, the ratio L₁/L₂ of the total length L₁ of all gaps whose widths are greater than or equal to 2 nm to the circumference L₂ of the cross sections is less than or equal to 0.3. In some embodiments of this application, in the cross sections of the first monocrystalline particles, the ratio L₁/L₂ of the total length L₁ of all gaps whose widths are greater than or equal to 2 nm to the circumference L₂ of the cross sections is less than or equal to 0.2. Specifically, in some embodiments, in the cross sections of the first monocrystalline particles, the ratio L₁/L₂ of the total length L₁ of all gaps whose widths are greater than or equal to 2 nm to the circumference L₂ of the cross sections is 0.45, 0.4, 0.35, 0.3, 0.25, 0.2, 0.15, 0.1, 0.05, or 0.01. A smaller ratio L₁/L₂ indicates fewer cracks and defects of a monocrystalline particle product. In some embodiments, in the cross sections of the first monocrystalline particles, the ratio L₁/L₂ of the total length L₁ of all gaps whose widths are greater than or equal to 2 nm to the circumference L₂ of the cross sections is 0. This indicates that there is no gap whose width is greater than or equal to 2 nm in the cross sections of the first monocrystalline particles. The monocrystalline particle in this embodiment of this application is obtained through modification. In some embodiments of this application, there may be some gaps whose widths are less than 2 nm in the monocrystalline particle bulk phase. In some embodiments of this application, in the cross sections of the first monocrystalline particles, a ratio L₁'/L₂ of a total length L₁' of all gaps whose widths are greater than or equal to 1 nm to the circumference L₂ of the cross sections is less than or equal to 0.45. In some embodiments, in the cross sections of the first monocrystalline particles, the ratio L₁'/L₂ of the total length L₁' of all gaps whose widths are greater than or equal to 1 nm to the circumference L₂ of the cross sections is less than or equal to 0.2. In some embodiments of this application, in the cross sections of the first monocrystalline particles, a ratio L₁"/L₂ of a total length L₁" of all gaps whose widths are greater than or equal to 0.5 nm to the circumference L₂ of the cross sections is less than or equal to 0.45. In some embodiments, in the cross sections of the first monocrystalline particles, the ratio L₁"/L₂ of the total length L₁" of all gaps whose widths are greater than or equal to 0.5 nm to the circumference L₂ of the cross sections is less than or equal to 0.2.

In this implementation, the m monocrystalline particles include the n first monocrystalline particles, and the ratio n/m of n to m is greater than or equal to 0.5, that is, in the m monocrystalline particles, the quantity of the first monocrystalline particles is greater than or equal to 50%, where m ≥ 10. To be specific, m monocrystalline particle products may be randomly selected and cut to obtain cross sections for measurement, to obtain the ratios n/m and L₁/L₂. The cross sections of the first monocrystalline particles may be any cross sections of the first monocrystalline particles. During actual evaluation, a group of m monocrystalline particle products may be randomly selected and cut to obtain cross sections for measurement; or a plurality of groups of m monocrystalline particle products may be randomly selected and cut to obtain cross sections for measurement. Each monocrystalline particle may be cut to obtain one cross section for measurement, or may be cut to obtain a plurality of cross sections for measurement. The cross sections obtained by cutting the monocrystalline particles may be characterized by using a scanning electron microscope, to obtain the total length L₁ of all gaps whose widths are greater than or equal to 2 nm in all the cross sections, and the circumference L₂ of the cross sections, and L₁ and L₂ may also be obtained with the help of software. It is to be noted that, in an actual characterization process, an allowable error, for example, an instrument error, may exist in obtaining the foregoing parameter values. In this application, a cross section of the first monocrystalline particle is a complete cross section of the monocrystalline particle, and m may be any value greater than or equal to 10, such as 10, 20, 50, or 100. In some implementations of this application, in the m monocrystalline particles, a quantity of the first monocrystalline particles is greater than or equal to 60%, that is, n/m ≥ 0.6. In some implementations, in the m monocrystalline particles, a quantity of the first monocrystalline particles is greater than or equal to 70%, that is, n/m ≥ 0.7. In some implementations, in the m monocrystalline particles, a quantity of the first monocrystalline particles is greater than or equal to 80%, that is, n/m ≥ 0.8. In some implementations, in the m monocrystalline particles, a quantity of the first monocrystalline particles is greater than or equal to 90%, that is, n/m ≥ 0.9. It may be understood that a larger quantity of the first monocrystalline particles, that is, a larger ratio n/m, indicates a higher yield of the crystal material.

Refer to FIG. 3. In some other implementations of this application, the crystal material 100 is a mono-like crystalline particle, and the crystal material 100 includes a plurality of (two or more) monocrystalline grains 101, that is, is a secondary particle formed by stacking and agglomerating the plurality of monocrystalline grains 101. In this implementation, the crystal material 100 may be of various regular or irregular shapes. There are grain boundaries 102 between the plurality of stacked monocrystalline grains 101. In a cross section of the secondary particle of the crystal material, a ratio L₃/L₄ of a grain boundary length L₃ of a grain boundary 102 at which a width of an intergranular gap is greater than or equal to 2 nm to a total grain boundary length L₄ is less than or equal to 0.8, that is, a ratio of a grain boundary length of a grain boundary at which a width of an intergranular gap is less than 2 nm to the total grain boundary length L₄ is greater than or equal to 0.2. In this implementation of this application, adjacent monocrystalline grains are fused at a grain boundary to form a mono-like crystalline (quasi-monocrystalline) or twin crystal structure, and a phase change and a defect at the fusion grain boundary are repaired, to form a grain boundary at which a width of an intergranular gap is less than 2 nm. In the crystal material 100 of this application, grain boundary fusion, that is, intergranular gap reduction, can effectively improve a diffusion kinetics process of ions in the crystal material particle, improve ionic conductivity of the material, and suppress crack extension, thereby improving structural stability of the crystal material, and further improving thermal stability and a cycle life of the material.

Refer to FIG. 4. In some other implementations of this application, the crystal material 100 is a polycrystalline particle, and the crystal material 100 includes a plurality of (two or more) monocrystalline grains 101, that is, is formed by stacking and agglomerating the plurality of monocrystalline grains 101. In this implementation, the crystal material 100 may be of various regular or irregular shapes, and the polycrystalline particle is usually a spherical or spherical-like particle. There are grain boundaries between the plurality of stacked monocrystalline grains 101. In a cross section of the secondary particle of the crystal material, a ratio L₃/L₄ of a grain boundary length L₃ of a grain boundary at which a width of an intergranular gap is greater than or equal to 2 nm to a total grain boundary length L₄ is less than or equal to 0.8, that is, a ratio of a grain boundary length of a grain boundary at which a width of an intergranular gap is less than 2 nm to the total grain boundary length L₄ is greater than 0.2. In the crystal material 100 of this application, grain boundary fusion, that is, intergranular gap reduction, can effectively improve a diffusion kinetics process of ions in the crystal material particle, improve ionic conductivity of the material, and suppress crack extension, thereby improving structural stability of the crystal material, and further improving thermal stability and a cycle life of the material. As shown in FIG. 4, a grain boundary at which a width of an intergranular gap is greater than or equal to 2 nm is represented by a solid line, and a grain boundary at which a width of an intergranular gap is less than 2 nm is represented by a dashed line. In this case, a total length of all solid lines at the grain boundaries in a to-be-measured cross section of the secondary particle is L₃, and a total length of the solid lines and dashed lines is L₄.

In some implementations of this application, the secondary particle of the crystal material formed by stacking the plurality of monocrystalline grains includes the mono-like crystalline particle and the polycrystalline particle, and in the cross section of the secondary particle, the ratio of the grain boundary length L₃ of the grain boundary at which the width of the intergranular gap is greater than or equal to 2 nm to the total grain boundary length L₄ is less than or equal to 0.7, that is, the ratio of the grain boundary length of the grain boundary at which the width of the intergranular gap is less than 2 nm to the total grain boundary length L₄ is greater than 0.3. In some implementations of this application, in the cross section of the secondary particle, the ratio L₃/L₄ of the grain boundary length L₃ of the grain boundary at which the width of the intergranular gap is greater than or equal to 2 nm to the total grain boundary length L₄ is less than or equal to 0.5, that is, the ratio of the grain boundary length of the grain boundary at which the width of the intergranular gap is less than 2 nm to the total grain boundary length L₄ is greater than 0.5. Specifically, in the cross section of the secondary particle, the ratio L₃/L₄ of the grain boundary length L₃ of the grain boundary at which the width of the intergranular gap is greater than or equal to 2 nm to the total grain boundary length L₄ may be, for example, 0.1, 0.2, 0.25, 0.3, 0.35, 0.4, 0.5, 0.6, 0.7, or 0.8. Correspondingly, the ratio of the grain boundary length of the grain boundary at which the width of the intergranular gap is less than 2 nm to the total grain boundary length L₄ is 0.9, 0.8, 0.7, 0.65, 0.6, 0.5, 0.4, 0.3, or 0.2. In this implementation of this application, considering comprehensive performance of the crystal material, not only an ion diffusion capability of the material needs to be improved, but also an appropriate electrochemical active area needs to be exposed. In the cross section of the secondary particle, the ratio L₃/L₄ of the grain boundary length L₃ of the grain boundary at which the width of the intergranular gap is greater than or equal to 2 nm to the total grain boundary length L₄ may range from 0.2 to 0.5, that is, the ratio of the grain boundary length of the grain boundary at which the width of the intergranular gap is less than 2 nm to the total grain boundary length L₄ ranges from 0.5 to 0.8.

In some implementations of this application, in the cross section of the secondary particle, a ratio L₅/L₄ of a grain boundary length L₅ of a grain boundary at which a width of an intergranular gap is greater than or equal to 1.5 nm to the total grain boundary length L₄ is less than or equal to 0.8. In some embodiments, in the cross section of the secondary particle, the ratio of the grain boundary length L₅ of the grain boundary at which the width of the intergranular gap is greater than or equal to 1.5 nm to the total grain boundary length L₄ is less than or equal to 0.7, that is, the ratio of the grain boundary length of the grain boundary at which the width of the intergranular gap is less than 1.5 nm to the total grain boundary length L₄ is greater than 0.3. In some implementations of this application, in the cross section of the secondary particle, the ratio L₅/L₄ of the grain boundary length L₅ of the grain boundary at which the width of the intergranular gap is greater than or equal to 1.5 nm to the total grain boundary length L₄ is less than or equal to 0.5, that is, the ratio of the grain boundary length of the grain boundary at which the width of the intergranular gap is less than 1.5 nm to the total grain boundary length L₄ is greater than 0.5. Specifically, the ratio L₅/L₄ of the grain boundary length L₅ of the grain boundary at which the width of the intergranular gap is greater than or equal to 1.5 nm to the total grain boundary length L₄ may be, for example, 0.1, 0.2, 0.25, 0.3, 0.35, 0.4, 0.5, 0.6, 0.7, or 0.8. Correspondingly, the ratio of the grain boundary length of the grain boundary at which the width of the intergranular gap is less than 1.5 nm to the total grain boundary length L₄ is 0.9, 0.8, 0.7, 0.65, 0.6, 0.5, 0.4, 0.3, or 0.2.

In an implementation of this application, in the cross section of the secondary particle, a ratio L₆/L₄ of a grain boundary length L₆ of a grain boundary at which a width of an intergranular gap is greater than or equal to 1 nm to the total grain boundary length L₄ is less than or equal to 0.5. In some embodiments, the ratio of the grain boundary length L₆ of the grain boundary at which the width of the intergranular gap is greater than or equal to 1 nm to the total grain boundary length L₄ is less than or equal to 0.7, that is, the ratio of the grain boundary length of the grain boundary at which the width of the intergranular gap is less than 1 nm to the total grain boundary length L₄ is greater than 0.3. In some implementations of this application, the ratio L₆/L₄ of the grain boundary length L₆ of the grain boundary at which the width of the intergranular gap is greater than or equal to 1 nm to the total grain boundary length L₄ is less than or equal to 0.5, that is, the ratio of the grain boundary length of the grain boundary at which the width of the intergranular gap is less than 1 nm to the total grain boundary length L₄ is greater than 0.5. Specifically, the ratio L₆/L₄ of the grain boundary length L₆ of the grain boundary at which the width of the intergranular gap is greater than or equal to 1 nm to the total grain boundary length L₄ may be, for example, 0.1, 0.2, 0.25, 0.3, 0.35, 0.4, 0.5, 0.6, 0.7, or 0.8. Correspondingly, the ratio of the grain boundary length of the grain boundary at which the width of the intergranular gap is less than 1 nm to the total grain boundary length L₄ is 0.9, 0.8, 0.7, 0.65, 0.6, 0.5, 0.4, 0.3, or 0.2.

In an implementation of this application, in the cross section of the secondary particle, a ratio L₇/L₄ of a grain boundary length L₇ of a grain boundary at which a width of an intergranular gap is greater than or equal to 0.5 nm to the total grain boundary length L₄ is less than or equal to 0.5. In some embodiments, the ratio of the grain boundary length L₇ of the grain boundary at which the width of the intergranular gap is greater than or equal to 0.5 nm to the total grain boundary length L₄ is less than or equal to 0.7, that is, the ratio of the grain boundary length of the grain boundary at which the width of the intergranular gap is less than 0.5 nm to the total grain boundary length L₄ is greater than 0.3. In some implementations of this application, the ratio L₇/L₄ of the grain boundary length L₇ of the grain boundary at which the width of the intergranular gap is greater than or equal to 0.5 nm to the total grain boundary length L₄ is less than or equal to 0.5, that is, the ratio of the grain boundary length of the grain boundary at which the width of the intergranular gap is less than 0.5 nm to the total grain boundary length L₄ is greater than 0.5. Specifically, the ratio L₇/L₄ of the grain boundary length L₇ of the grain boundary at which the width of the intergranular gap is greater than or equal to 0.5 nm to the total grain boundary length L₄ may be, for example, 0.1, 0.2, 0.25, 0.3, 0.35, 0.4, 0.5, 0.6, 0.7, or 0.8. Correspondingly, the ratio of the grain boundary length of the grain boundary at which the width of the intergranular gap is less than 0.5 nm to the total grain boundary length L₄ is 0.9, 0.8, 0.7, 0.65, 0.6, 0.5, 0.4, 0.3, or 0.2. In some embodiments of this application, that the width of the intergranular gap at the grain boundary is less than 0.5 nm indicates that atomic-level fusion is implemented at the grain boundary.

In this application, the cross section of the secondary particle of the crystal material is obtained by cutting, and may be any cross section obtained by cutting the secondary particle. The cross section obtained by cutting may be characterized by using a scanning electron microscope, to obtain the total grain boundary length L₃ with widths of all intergranular gaps greater than or equal to 2 nm in the entire cross section, and obtain the total grain boundary length L₄ of all grain boundaries in the complete particle cross section. L₅, L₆, and L₇ may also be measured by using the foregoing method. It may be understood that a characterization instrument configured to obtain the L₁, L₂, L₃, L₄, L₅, and L₆ may alternatively be another instrument that can clearly obtain the foregoing parameter values, and the foregoing parameter values may also be obtained with the help of software. It is to be noted that, in an actual characterization process, an allowable error, for example, an instrument error, may exist in obtaining the foregoing parameter values. The secondary particle may be cut to obtain one cross section for measurement, or may be cut to obtain a plurality of cross sections for measurement.

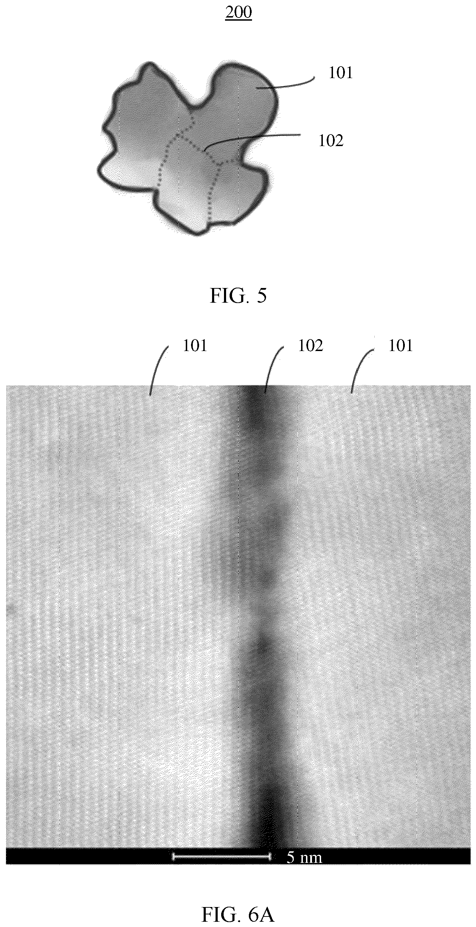

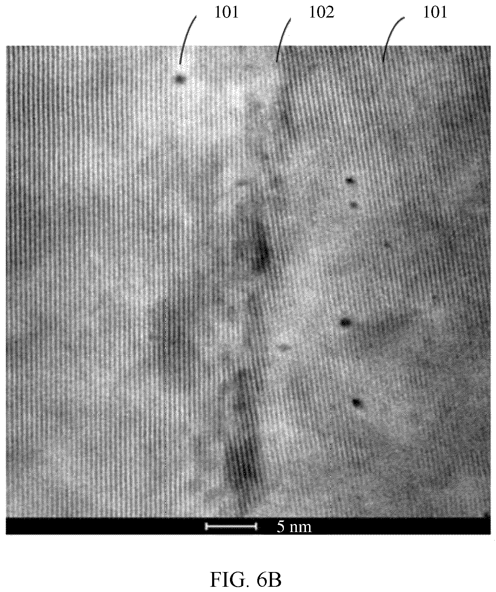

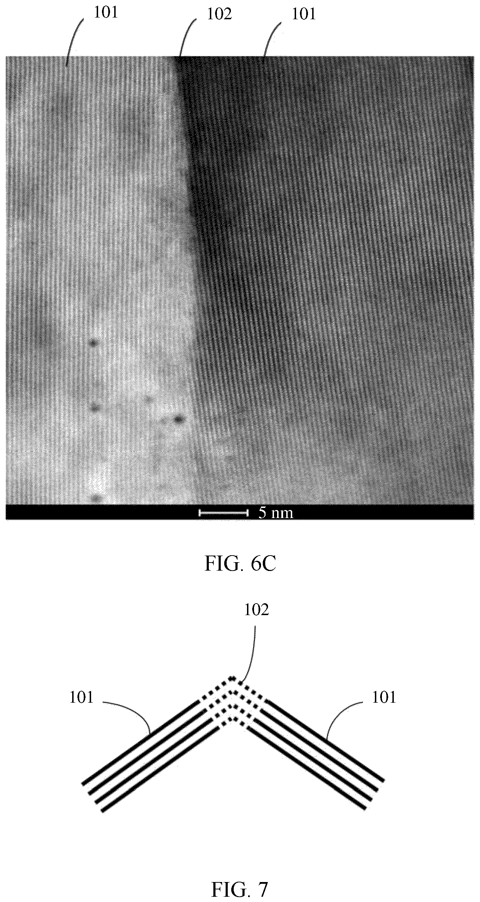

FIG. 5 is a diagram of a structure of a grain boundary in a crystal material 100 according to an embodiment of this application. FIG. 6A, FIG. 6B, and FIG. 6C are spherical aberration electron microscope graphs of grain boundaries between grains of a crystal material 100 according to an embodiment of this application. In an implementation of this application, in a plurality of monocrystalline grains 101 of a secondary particle, at least some adjacent monocrystalline grains 101 are fused at a grain boundary 102 to form a grain boundary-modified agglomerate 200, each grain boundary-modified agglomerate 200 includes two or more monocrystalline grains 101, and in the grain boundary-modified agglomerate 200, a width of an intergranular gap at a grain boundary at which monocrystalline grains are fused is less than 2 nm. Each polycrystalline secondary particle may include a plurality of grain boundary-modified agglomerates 200.

In some implementations of this application, fusion of the at least some adjacent monocrystalline grains at the grain boundary is crystal-face atomic-level epitaxial junction fusion of the adjacent monocrystalline grains, that is, intergranular interfaces are highly fused to form a structure with a co-grain boundary. In this case, the width of the gap between the monocrystalline grains is less than or equal to 0.5 nm.

FIG. 7 is a diagram of crystal-face atomic-level epitaxial junction fusion of adjacent grains in a crystal material according to this application. The crystal-face atomic-level epitaxial junction fusion of the adjacent grains is that the grain boundary between the adjacent grains is obtained through epitaxial growth along the crystal faces of the adjacent grains toward each other, so that an original gap at the grain boundary is smaller. Refer to FIG. 6C. It can be learned from FIG. 6C that the adjacent grains 101 of the crystal material 100 in this embodiment of this application are highly fused at the grain boundary 102, implementing the atomic-level epitaxial fusion, and the gap at the grain boundary is less than 0.5 nm, nearly 0 nm.

It can be learned by comparing FIG. 4 with FIG. 1A, comparing FIG. 5 with FIG. 1B, and comparing FIG. 6A, FIG. 6B, and FIG. 6C with FIG. 1C that, compared with the existing polycrystalline positive-electrode material 10, the polycrystalline material 100 in embodiments of this application has a greatly reduced intergranular gap, a high intergranular fusion degree, and strong bonding, so that ionic conductivity and electron conductivity of the material can be improved, structural stability of the material can be improved, crack growth can be suppressed, and cycle stability and thermal stability of the material can be improved.

In an implementation of this application, in the cross section of the secondary particle of the crystal material, a continuous grain boundary length of a grain boundary at which a width of an intergranular gap is less than 2 nm is long, and a modification degree of the grain boundaries is high. In some implementations of this application, the continuous grain boundary length of the grain boundary at which the width of the intergranular gap is less than 2 nm is greater than or equal to 10 nm. In some embodiments, a continuous grain boundary length of a grain boundary at which a width of an intergranular gap is less than 2 nm is 10 nm to 1000 nm. In some implementations of this application, a continuous grain boundary length of a grain boundary at which a width of an intergranular gap is less than 1.5 nm is 10 nm to 1000 nm. In some implementations of this application, a continuous grain boundary length of a grain boundary at which a width of an intergranular gap is less than 1 nm is 10 nm to 1000 nm. In some implementations of this application, a continuous grain boundary length of a grain boundary at which a width of an intergranular gap is less than 0.5 nm is 10 nm to 1000 nm.

In some implementations of this application, in the secondary particle, there is no impurity element, different from each element in adjacent monocrystalline grains, at a grain boundary between the adjacent monocrystalline grains, that is, no impurity element different from all elements in the monocrystalline grains on both sides of the grain boundary exists at the grain boundary. In other words, in this implementation, after grain boundary modification, no other impurity element different from all elements in the adjacent monocrystalline grains is introduced at the grain boundary between the adjacent monocrystalline grains 101, and the grain boundary modification is homogeneous modification. In this way, a crystal structure of the crystal material primary product can be better repaired, and uniformity and consistency of internal element composition and a crystal structure of the crystal material can be maintained. In this implementation, in the secondary particle, elements at the grain boundary between the adjacent monocrystalline grains 101 are partially or completely the same as all elements in each of the adjacent monocrystalline grains. In some implementations of this application, in the secondary particle, the elements at the grain boundary between the adjacent monocrystalline grains 101 are at least partially or completely the same as the elements in one of the adjacent monocrystalline grains, that is, the elements at the grain boundary may include some elements in one of the adjacent monocrystalline grains, or may include all elements in one of the adjacent monocrystalline grains. For example, if one of the adjacent monocrystalline grains includes nickel, cobalt, manganese, lithium, and oxygen, the grain boundary may include some or all elements of nickel, cobalt, manganese, lithium, and oxygen.

For the foregoing homogeneous modification, that is, the implementation in which there is no impurity element, different from each element in any adjacent monocrystalline grains, at a grain boundary between the adjacent monocrystalline grains, in some embodiments, the grain boundary between the adjacent monocrystalline grains is a crystal structure obtained through epitaxial growth along atomic arrangements of the adjacent monocrystalline grains. The atomic-level epitaxial growth at the grain boundary can reduce the intergranular gaps at at least some grain boundaries in the secondary particle to 2 nm or less. In some embodiments, the atomic-level epitaxial growth at the grain boundary reduces intergranular gaps at some grain boundaries to 0.5 nm or less, thereby implementing atomic-level epitaxial junction fusion.

For the foregoing homogeneous modification, that is, the implementation in which there is no impurity element, different from each element in any adjacent monocrystalline grains, at a grain boundary between the adjacent monocrystalline grains, in some other embodiments, the grain boundary between the adjacent monocrystalline grains is filled with a first metal salt, where the first metal salt is an alkali metal salt or an alkaline earth metal salt that has a same alkali metal or alkaline earth metal element as the adjacent monocrystalline grains, and the first metal salt includes no impurity element different from all elements in the adjacent monocrystalline grains. For example, if the monocrystalline grain is a lithium-ion battery electrode material or a lithium-ion battery solid-state electrolyte, the first metal salt is a lithium supplement, that is, a lithium salt. The lithium supplement may include, for example, one or more of Li₅FeO₄, Li₆CoO₄, Li₂C₂O₄, Li₂C₄O₄, Li₃N, Li₂NiO₂, and Li₂CuO₂. If the monocrystalline grain is a sodium-ion battery electrode material or a sodium-ion battery solid-state electrolyte, the first metal salt is a sodium supplement, that is, a sodium salt. The sodium supplement may be, for example, one or more of Na₅FeO₄, Na₆CoO₄, Na₂C₂O₄, Na₂C₄O₄, Na₃N, Na₂NiO₂, and Na₂CuO₂. In this implementation, filling the grain boundary with the first metal salt can reduce the intergranular gaps at at least some grain boundaries in the secondary particle to 2 nm or less. In some embodiments, intergranular gaps at some grain boundaries can be reduced to 0.5 nm or less, thereby implementing atomic-level grain boundary fusion.

In some other implementations of this application, in the secondary particle, there is an impurity element, different from each element in any adjacent monocrystalline grains, at a grain boundary between the adjacent monocrystalline grains. In other words, in this implementation, after grain boundary modification, another impurity element different from all elements in the adjacent monocrystalline grains is introduced at the grain boundary between the adjacent monocrystalline grains 101, and the grain boundary modification is heterogeneous modification. In some embodiments, the grain boundary between the adjacent monocrystalline grains is filled with a second metal salt, where the second metal salt is an alkali metal salt or an alkaline earth metal salt that has a same alkali metal or alkaline earth metal element as the adjacent monocrystalline grains, and the second metal salt includes an impurity element different from all elements in adjacent monocrystalline grains. For example, if the monocrystalline grain is a lithium-ion battery electrode material or a lithium-ion battery solid-state electrolyte, the second metal salt is a lithium supplement, that is, a lithium salt. The lithium supplement may include, for example, one or more of Li₅FeO₄, Li₆CoO₄, Li₂C₂O₄, Li₂C₄O₄, Li₃N, Li₂NiO₂, and Li₂CuO₂. If the monocrystalline grain is a sodium-ion battery electrode material or a sodium-ion battery solid-state electrolyte, the second metal salt is a sodium supplement, that is, a sodium salt. The sodium supplement may be, for example, one or more of Na₅FeO₄, Na₆CoO₄, Na₂C₂O₄, Na₂C₄O₄, Na₃N, Na₂NiO₂, and Na₂CuO₂.

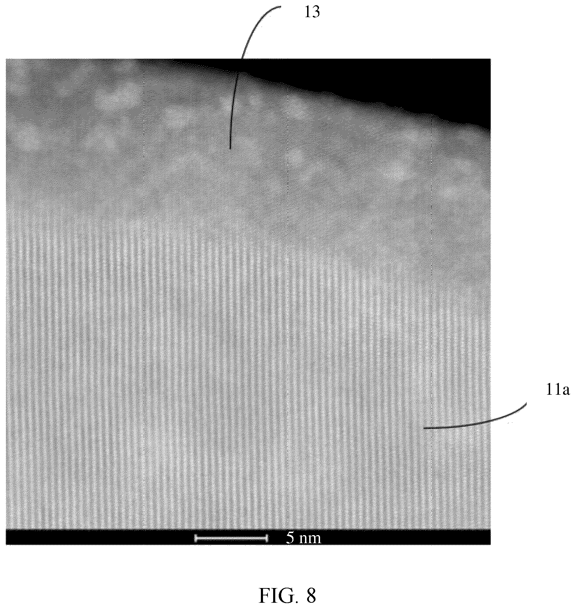

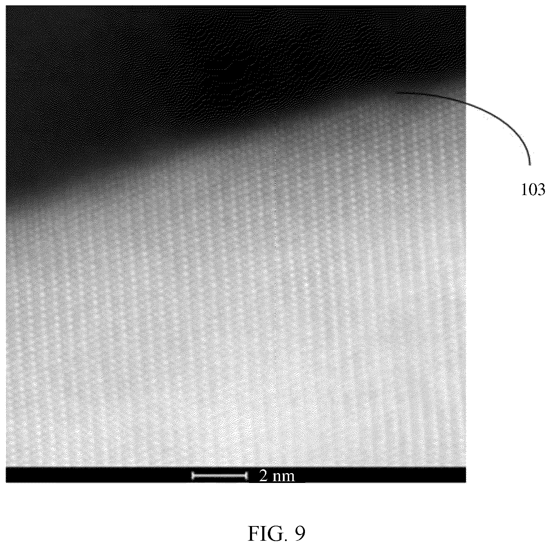

In this implementation of this application, as the grain boundary of the crystal material 100 is modified, a thickness of a phase change layer on a surface of the monocrystalline grain is small. In some embodiments, the thickness of the phase change layer on the surface of the monocrystalline grain is less than or equal to 1 nm. In some embodiments, the thickness of the phase change layer on the surface of the monocrystalline grain is less than or equal to 0.5 nm. In some embodiments, the thickness of the phase change layer on the surface of the monocrystalline grain may be 1 nm, 0.8 nm, 0.7 nm, 0.6 nm, 0.5 nm, 0.4 nm, 0.3 nm, 0.2 nm, 0.1 nm, or the like. In some embodiments, the thickness of the phase change layer on the surface of the monocrystalline grain is less than or equal to 0.1 nm. In some embodiments, the thickness of the phase change layer on the surface of the monocrystalline grain is equal to 0 nm. The phase change layer is a surface-phase structure change layer that is formed by surface reconstruction of the monocrystalline grain and that is not completely consistent with a structure phase of the monocrystalline grain. FIG. 8 is an electron microscope graph of a phase change layer on a surface of a grain of a crystal material before modification according to an embodiment of this application. FIG. 9 is an electron microscope graph of a phase change layer on a surface of a grain of a crystal material according to an embodiment of this application. It can be learned from FIG. 8 that, before the crystal material is modified, an atomic arrangement structure of a phase change layer 13 on the surface of the monocrystalline grain is different from that of a grain body 11a, namely, an interior of the grain. It can be learned by comparing FIG. 8 with FIG. 9 that, in the crystal material 100 in embodiments of this application, a thickness of a phase change layer 103 on the surface of the monocrystalline grain is significantly smaller than a thickness of the phase change layer 13 on the surface of the grain of the crystal material before modification, and there is almost no visible phase change layer in FIG. 9, that is, the thickness of the phase change layer 103 is nearly 0. A smaller thickness of the phase change layer indicates higher consistency of the overall crystal structure of the particle, which is more conducive to improving performance of the crystal material and improving a transmission kinetics process of ions.

In some implementations of this application, the secondary particle formed by stacking the plurality of monocrystalline grains includes the mono-like crystalline particle or the polycrystalline particle, and in the cross sections of some or all monocrystalline grains that form the secondary particle, a ratio L₁/L₂ of a total length L₁ of all gaps whose widths are greater than or equal to 2 nm to an average value L₂ of a size between two farthest points and a size between two nearest points of the cross sections is less than or equal to 0.1, that is, the secondary particle has a feature the same as that of the first monocrystalline particle described above.

A particle size of the crystal material 100 in embodiments of this application is related to a material type and a preparation process, and may be controlled based on a requirement. A size of the secondary particle of the crystal material 100 may be less than or equal to 50 µm. In some embodiments, the size of the secondary particle of the crystal material 100 may be 3 µm to 50 µm. In an implementation of this application, in the plurality of stacked monocrystalline grains 101 of the secondary particle, crystal face orientations of two adjacent monocrystalline grains 101 are random. Components and crystal structures of the two adjacent monocrystalline grains 101 may be the same or may be different.

In an implementation of this application, the monocrystalline grain 101 is a battery electrode material or a solid-state electrolyte. The battery electrode material may include a battery positive-electrode material or a battery negative-electrode material.

In an implementation of this application, the battery electrode material is a composite oxide including an alkali metal or an alkaline earth metal.

In an implementation of this application, the battery electrode material includes a lithium-ion battery electrode material, a sodium-ion battery electrode material, a potassium-ion battery electrode material, or a magnesium-ion battery electrode material.

In an implementation of this application, the lithium-ion battery electrode material includes a lithium-containing composite oxide. The lithium-containing composite oxide includes one or more of a lithium-cobalt oxide (for example, lithium cobaltate LiCoO₂), a lithium-nickel oxide (for example, lithium nickelate LiNiO₂), a lithium-manganese oxide (for example, lithium manganate LiMnO₂ or lithium permanganate), a lithium-titanium oxide (for example, lithium titanate), a lithium-iron-phosphorus oxide (for example, lithium iron phosphate), a lithium-nickel-cobalt oxide (for example, lithium nickel cobaltate LiNiₐCo₁₋ₐO₂), a lithium-nickel-manganese oxide (for example, lithium nickel manganate LiNiₐMn₁₋ₐO₂), and a nickel-cobalt multi-element oxide (for example, lithium nickel cobalt manganate LiNiₐCo_{b}Mn_{1-a-b}O₂, lithium nickel cobalt aluminate LiNiₐCo_{b}Al_{1-a-b}O₂, or lithium nickel cobalt manganese aluminate LiNiₐCo_{b}Mn_{c}Al_{1-a-b-c}O₂), where 0 < a < 1, 0 < b < 1, 0 < c < 1, 0 < 1-a-b < 1, and 0 < 1-a-b-c < 1. The lithium-containing composite oxide may be a lithium-containing oxide in a stoichiometric ratio or may be a lithium-containing oxide in a non-stoichiometric ratio. For example, in the lithium-ion battery electrode material Li_{η}NiₐCo_{b}Mn_{c}Al_{1-a-b-c}O₂, η may be any value greater than 0 and less than or equal to 2, 0 ≤ a ≤ 1, 0 ≤ b ≤ 1, 0 ≤ c ≤ 1, and 0 ≤ 1-a-b-c ≤ 1.

In an implementation of this application, the sodium-ion battery electrode material includes one or more of a sodium-containing composite oxide, Prussian blue, and Prussian white. The sodium-containing composite oxide includes a sodium-containing transition metal oxide, which may include one or more of a sodium-manganese oxide, a sodium-copper-iron-manganese oxide, a sodium-nickel-iron-manganese oxide, and a sodium-copper-nickel-iron-manganese oxide.

In an implementation of this application, the potassium-ion battery electrode material includes a potassium-containing composite oxide. The potassium-containing composite oxide may be, for example, a potassium-cobalt oxide, a potassium-manganese oxide, or a potassium-iron-manganese oxide. In an implementation of this application, the magnesium-ion battery electrode material includes a magnesium-containing composite oxide. The magnesium-containing composite oxide may be, for example, a magnesium-vanadium oxide, a magnesium-cobalt-manganese oxide, a magnesium-nickel-manganese oxide, a magnesium-manganese oxide, or a magnesium-iron-manganese oxide.

In an implementation of this application, the solid-state electrolyte includes one or more of an oxide-type solid-state electrolyte, a sulfide-type solid-state electrolyte, and a halogenated solid-state electrolyte. The solid-state electrolyte may be a lithium-ion battery solid-state electrolyte, a sodium-ion battery solid-state electrolyte, a potassium-ion battery solid-state electrolyte, or a magnesium-ion battery solid-state electrolyte. Using the lithium-ion battery solid-state electrolyte as an example, the crystal material may be Li₂ZrF₆, Li₃AlF₆, LiYF₄, LiF, Li₂CdCl₄, LiAlCl₄, Li₂ZnCl₄, Li₂MgCl₄, LiCl, Li₃InBr₆, Li₂MnBr₄, Li₂ZnBr₄, LiAlBr₄, Li₂MgBr₄, LiBr, Li₃OCl, LiTi₂(PO₄)₃, LiGe₂(PO₄)₃, Li₃PO₄, LiNbO₃, Li₄GeO₄, Li₇La₃ZrO₁₂, Li₂ZrO₃, Li₄Ti₅O₁₂, LiAlO₂, Li₂O, Li₃PS₄, Li₄SnS₄, Li₁₀GeP₂S₁₂, Li₃S, or the like.

The crystal material provided in this application includes a battery electrode material or a solid-state electrolyte material, and has a highly fused co-grain boundary structure, which can improve a transmission kinetics process at the grain boundary and improve initial coulombic efficiency of the material. In addition, the strongly bonded grain boundary formed by grain boundary fusion can effectively suppress crack extension, improve structural stability of the material, reduce active sites that have side reactions with the electrolyte, suppress an oxygen escape in a high delithiation state, improve thermal stability of the material, and further prolong a cycle life.

An embodiment of this application further provides a method for preparing a crystal material, including the following steps:
Step (1): Mix a to-be-modified crystal material primary product with a metal salt to obtain a mixture, heat the mixture to melt the metal salt, and then cool the mixture, where a metal element of the metal salt is an alkali metal element or an alkaline earth metal element that is the same as that of the crystal material primary product.
Step (2): Collect the cooled mixture to obtain the crystal material; or introduce oxygen or inert gas into the cooled mixture, and heat to 400°C to 900°C and keep at the same temperature for 1 hour to 12 hours, to obtain the crystal material.

In an implementation of this application, in step (1), a molar mass of the metal salt is 0.1 % to 20% of a molar mass of the crystal material primary product. In some embodiments, the molar mass of the metal salt is 0.1% to 10% of the molar mass of the crystal material primary product. In some embodiments, the molar mass of the metal salt is 0.2% to 8% of the molar mass of the crystal material primary product. In an implementation of this application, the to-be-modified crystal material primary product is a crystal material that has been sintered and crystallized, for example, may be various existing battery positive-electrode materials, negative-electrode materials, and solid-state electrolytes.

In an implementation of this application, the metal salt may include one metal salt or may include a plurality of metal salts. When one metal salt is included, the metal salt may be a metal salt whose melting point is less than 500°C. In some implementations, the metal salt may be a metal salt whose melting point is less than 300°C. In some implementations, the metal salt may be a metal salt whose melting point is less than 150°C. When a plurality of metal salts are included, the metal salt may include mixed and eutectic metal salts whose melting point is less than 300°C.

In an implementation of this application, a type of the metal salt is determined based on a type of the to-be-modified crystal material primary product, and a metal element in the metal salt is an alkali metal element or an alkaline earth metal element that is the same as that in the crystal material primary product. The to-be-modified crystal material primary product may be a lithium-ion battery electrode material, a sodium-ion battery electrode material, a potassium-ion battery electrode material, a magnesium-ion battery electrode material, a lithium-ion battery solid-state electrolyte, a sodium-ion battery solid-state electrolyte, a potassium-ion battery solid-state electrolyte, or a magnesium-ion battery solid-state electrolyte. In this case, in the metal salt, the alkali metal element may include one or more of a lithium element, a sodium element, and a potassium element, and the alkaline earth metal element may include a magnesium element. In some embodiments of this application, when the crystal material primary product is a lithium-ion battery electrode material or a lithium-ion battery solid-state electrolyte, that is, when the crystal material primary product includes a lithium element, the metal salt includes a lithium salt. The lithium salt may be specifically one or more of lithium nitrate, lithium hydroxide, lithium carbonate, and a lithium supplement. The lithium supplement may include, for example, one or more of Li₅FeO₄, Li₆CoO₄, Li₂C₂O₄, Li₂C₄O₄, Li₃N, Li₂NiO₂, and Li₂CuO₂. In some embodiments of this application, when the crystal material primary product is a sodium-ion battery electrode material or a sodium-ion battery solid-state electrolyte, that is, when the crystal material primary product includes a sodium element, the metal salt includes a sodium salt. The sodium salt may be specifically one or more of sodium nitrate, sodium hydroxide, sodium carbonate, and a sodium supplement. The sodium supplement may be, for example, one or more of Na₅FeO₄, Na₆CoO₄, Na₂C₂O₄, Na₂C₄O₄, Na₃N, Na₂NiO₂, and Na₂CuO₂. In some embodiments of this application, when the crystal material primary product is a potassium-ion battery electrode material or a potassium-ion battery solid-state electrolyte, that is, when the crystal material primary product includes a potassium element, the metal salt includes a potassium salt. The potassium salt may be specifically one or more of potassium nitrate, potassium hydroxide, and potassium carbonate. In some embodiments of this application, when the crystal material primary product is a magnesium-ion battery electrode material or a magnesium-ion battery solid-state electrolyte, that is, when the crystal material primary product includes a magnesium element, the metal salt includes a magnesium salt. The magnesium salt may be specifically one or more of magnesium nitrate, magnesium hydroxide, and magnesium carbonate.

In an implementation of this application, the metal salt is heated to 100°C to 750°C to be melted, kept at the same temperature for 1 hour to 12 hours. The cooling may be specifically natural cooling to room temperature. In some embodiments, temperature for heating the metal salt to be melted may be 200°C to 550°C, and a heat preservation time may be 2 hours to 10 hours or 4 hours to 6 hours. The heating temperature may be set based on a specific type of the metal salt.

In an implementation of this application, in step (2), temperature for heating and calcination may be adjusted based on a type of the to-be-modified crystal material primary product and a type of the metal salt. The heating temperature may be specifically 400°C, 450°C, 500°C, 550°C, 600°C, 650°C, 700°C, 750°C, 800°C, 900°C, or the like. A heat preservation time may be 1 hour, 3 hours, 5 hours, 6 hours, 8 hours, 10 hours, 12 hours, or the like. In step (2), the introduced oxygen or inert gas may be determined based on the composition of the crystal material. For alkali metal and alkaline earth metal oxide positive-electrode materials and solid-state electrolytes, a calcination atmosphere is usually oxygen. For non-oxygen compounds such as sulfides and halides, a calcination atmosphere is usually inert gas, such as nitrogen and argon.

In an implementation of this application, a lithium-ion battery electrode material or a lithium-ion battery solid-state electrolyte is used as an example. When the metal salt is lithium nitrate, lithium hydroxide, or lithium carbonate, and undergoes calcination in step (2), a crystal material whose grain boundary is a crystal structure obtained through epitaxial growth along atomic arrangements of adjacent monocrystalline grains toward each other can be obtained. When the metal salt is a lithium supplement, and an element of the lithium supplement is the same as an element of a monocrystalline grain, melting in step (1) is performed, without calcination in step (2), to obtain a crystal material whose grain boundary is filled with the metal salt that includes only an element the same as that of adjacent monocrystalline grains. For example, a primary product LiNi_{0.82}Co_{0.12}Mn_{0.06}O₂ is modified with a lithium supplement Li₂NiO₂. When the metal salt is a lithium supplement, and elements of the lithium supplement include an element different from those of a monocrystalline grain, melting in step (1) is performed, without calcination in step (2), to obtain a crystal material whose grain boundary is filled with the metal salt that includes an element different from those in the monocrystalline grain. For example, a primary product LiNi_{0.82}Co_{0.12}Mn_{0.06}O₂ is modified with a lithium supplement Li₂C₄O₄.

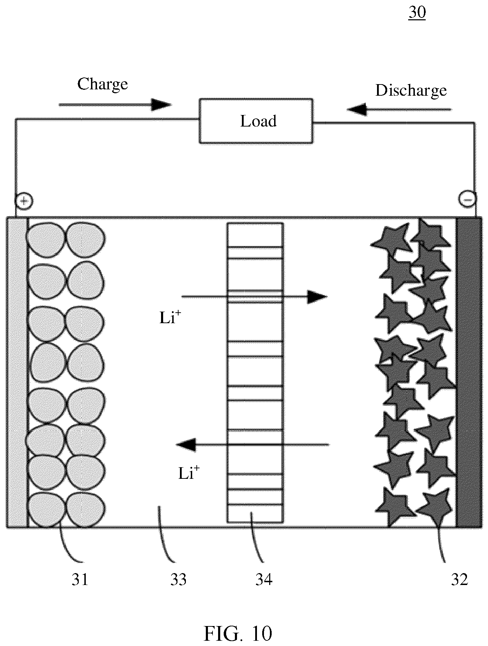

Refer to FIG. 10. An embodiment of this application further provides a battery 30, and the battery 30 includes the crystal material 100 provided in embodiments of this application. The crystal material 100 may be a battery electrode material or may be a solid-state electrolyte. The battery 30 may be a liquid electrolyte battery, a semi-solid-state battery, or an all-solid-state battery. The battery 30 may be a lithium-ion secondary battery, a sodium-ion secondary battery, a potassium-ion secondary battery, a magnesium-ion secondary battery, or the like. In some embodiments, the battery 30 includes a positive electrode 31, a negative electrode 32, an electrolyte 33, and a separator 34. Using a lithium-ion battery as an example, in a charge process, under the action of an external circuit, lithium ions deintercalate from a positive-electrode active substance and intercalate into a negative electrode through an electrolyte and a separator. At the same time, the positive electrode loses electrons, and the electrons flow out of the external circuit through a current collector. Conversely, in a discharge process, lithium ions deintercalate from the negative electrode and return to the positive electrode. At the same time, electrons move from the negative electrode to the positive electrode through the external circuit, and work externally.

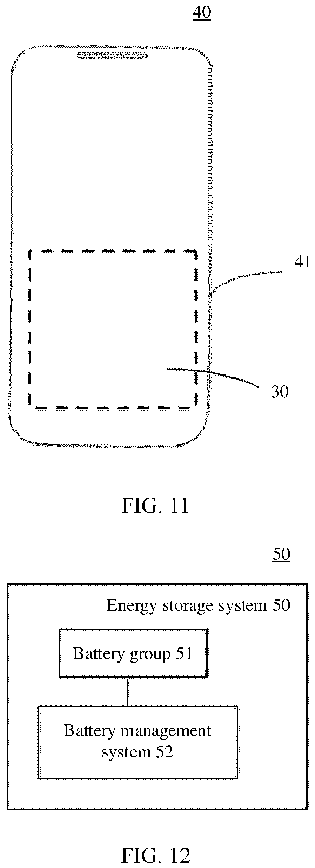

Refer to FIG. 11. An embodiment of this application further provides an electronic device 40, and the electronic device 40 includes the battery 30 provided in the foregoing embodiment of this application. The electronic device 40 may include various consumer electronic products, such as a mobile phone, a tablet computer, a mobile power supply, a portable computer, a notebook computer and another wearable or removable electronic device, a television, a video disc player, a video recorder, a camcorder, a radio, a radio recorder, a music center, a record player, a laser-disc player, a home office device, and a home electronic health care device, or may be an electronic product such as an automobile or an energy storage device. In some embodiments, the electronic device 40 includes a housing 41, an electronic component (not shown in the figure) accommodated in the housing 41, and the battery 30, and the battery 30 supplies power to the electronic device 40.

Refer to FIG. 12. An embodiment of this application further provides an energy storage system 50. The energy storage system 50 includes a battery group 51 and a battery management system 52 electrically connected to the battery group 51. The battery group 51 includes the battery 30 provided in the foregoing embodiment of this application.

The following further describes embodiments of this application in embodiments.

### Embodiment 1

A polycrystalline positive-electrode material LiNi_{0.82}Co_{0.12}Mn_{0.06}O₂ of a lithium-ion battery is used as an example. Grain boundary modification includes the following specific steps:
(1) 1 kg of polycrystalline positive-electrode material LiNi_{0.82}Co_{0.12}Mn_{0.06}O₂ was uniformly mixed with 8 mol% of lithium nitrate, to obtain a mixture.
(2) The mixture in (1) was heated to 500°C to melt lithium nitrate, kept at the same temperature for 3 hours, and was then cooled naturally to room temperature.
(3) Flow oxygen was introduced into the mixture obtained through the melting and impregnation in (2). The mixture was heated to 800°C, kept at the same temperature for 5 hours, and then cooled naturally to room temperature, to obtain a grain boundary-modified polycrystalline positive-electrode material LiNi_{0.82}Co_{0.12}Mn_{0.06}O₂.

### Lithium-ion battery preparation:

The grain boundary-modified polycrystalline positive-electrode material LiNi_{0.82}Co_{0.12}Mn_{0.06}O₂ obtained in Embodiment 1, polyvinylidene fluoride (PVDF), and a conductive agent super P were mixed at a mass ratio of 96:2:2, added with N-methylpyrrolidone (NMP), fully stirred, and uniformly mixed, to obtain a slurry. The slurry was coated on an aluminum-foil current collector. The collector was dried, cold pressed, and slit, to obtain a positive electrode plate. The obtained positive electrode plate, a lithium plate, an electrolyte, and a separator were made into a 2032 button battery.

### Comparative Example 1

A polycrystalline positive-electrode material LiNi_{0.82}Co_{0.12}Mn_{0.06}O₂ without grain boundary modification is used as a positive-electrode material in Comparative Example 1.

### Lithium-ion battery preparation:

The unmodified polycrystalline positive-electrode material LiNi_{0.82}Co_{0.12}Mn_{0.06}O₂ in Comparative Example 1, polyvinylidene fluoride (PVDF), and a conductive agent super P were mixed at a mass ratio of 96:2:2, added with N-methylpyrrolidone (NMP), fully stirred, and uniformly mixed, to obtain a slurry. The slurry was coated on an aluminum-foil current collector. The collector was dried, cold pressed, and slit, to obtain a positive electrode plate. The obtained positive electrode plate, a lithium plate, an electrolyte, and a separator were made into a 2032 button battery.

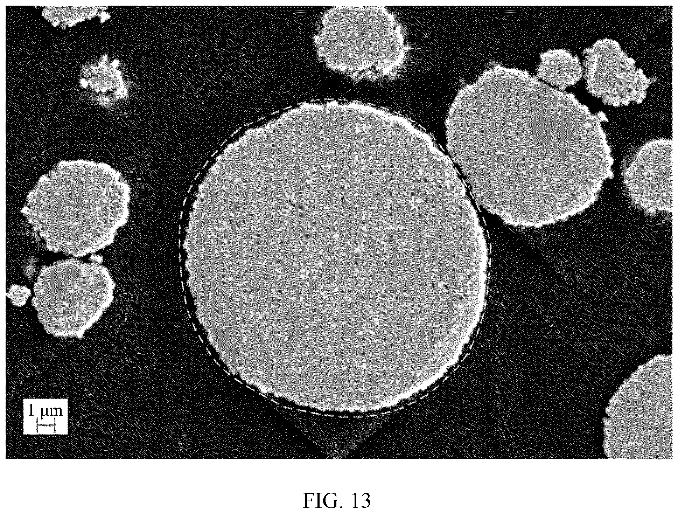

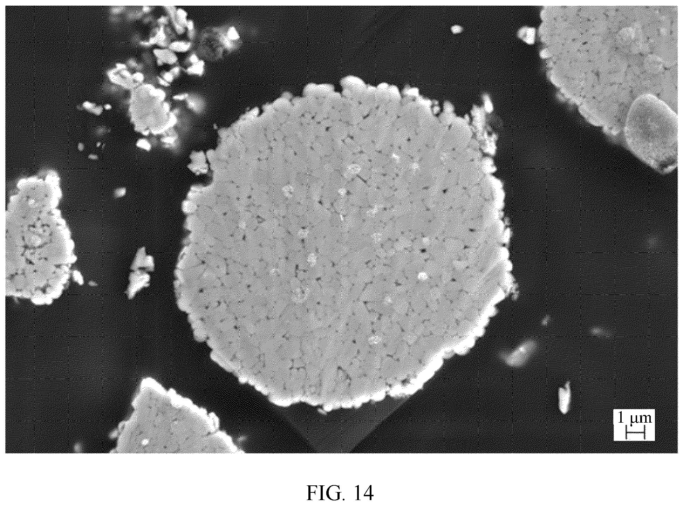

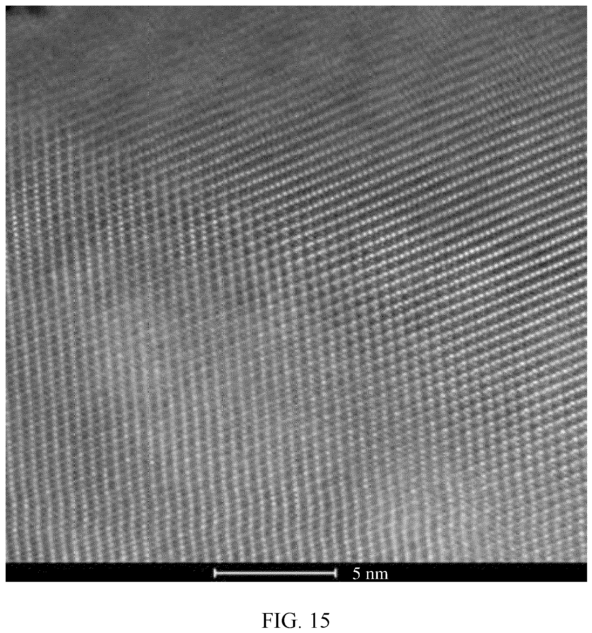

FIG. 13 is a SEM graph of a cross section of the grain boundary-modified polycrystalline positive-electrode material LiNi_{0.82}Co_{0.12}Mn_{0.06}O₂ according to Embodiment 1 of this application. FIG. 14 is a SEM graph of a cross section of the unmodified polycrystalline positive-electrode material LiNi_{0.82}Co_{0.12}Mn_{0.06}O₂ according to Comparative Example 1, that is, a SEM graph of a cross section of the positive-electrode material before modification in Embodiment 1. It can be learned from FIG. 13 and FIG. 14 that a sample without grain boundary modification in Comparative Example 1 is formed by stacking a plurality of primary particles (monocrystalline grains), and there is a clear grain boundary with a large gap between the primary particles; and for a grain boundary-modified sample in Embodiment 1 of this application, an intergranular gap at a grain boundary is significantly smaller than that before modification, clear grain boundaries are far less distributed, a secondary particle of the polycrystalline positive-electrode material includes a plurality of co-grain boundary agglomerates formed by primary particles, the primary particles in the co-grain boundary agglomerate are highly fused at the grain boundary with no clear gap, most gaps are less than 0.5 nm, and the primary particles are completely fused at some locations of the grain boundary with no gap. FIG. 15 is an electron microscope graph of atomic-level epitaxial junction fusion at a grain boundary between primary grains of the grain boundary-modified polycrystalline positive-electrode material LiNi_{0.82}Co_{0.12}Mn_{0.06}O₂ according to Embodiment 1 of this application. It can be learned from FIG. 15 that there is almost no intergranular gap at a location for atomic-level fusion implemented at the grain boundary between the primary particles, and atomic-level epitaxial junction fusion is implemented at the grain boundary.

It is obtained through detection that, in the cross section (for example, a cross section framed by a dashed line in FIG. 13) of the grain boundary-modified polycrystalline positive-electrode material LiNi_{0.82}Co_{0.12}Mn_{0.06}O₂ in Embodiment 1, a ratio of a grain boundary length of a grain boundary at which a width of an intergranular gap is greater than or equal to 0.5 nm to a total grain boundary length is less than 0.3. A continuous length of a grain boundary at which a width of an intergranular gap is less than 2 nm is 10 nm to 1000 nm. In FIG. 13, the cross section that is of the secondary particle and that is framed by the dashed line is a complete cross section of one secondary particle. FIG. 8 is an electron microscope graph of a phase change layer on a surface of a primary grain of the unmodified polycrystalline positive-electrode material LiNi_{0.82}Co_{0.12}Mn_{0.06}O₂ according to Comparative Example 1. FIG. 9 is an electron microscope graph of a phase change layer on a surface of a primary grain of the grain boundary-modified polycrystalline positive-electrode material LiNi_{0.82}Co_{0.12}Mn_{0.06}O₂ according to Embodiment 1 of this application. It can be learned from FIG. 8 and FIG. 9 that, for the sample without grain boundary modification in Comparative Example 1, there is a thick phase change layer on the surface of the primary grain, and for the grain boundary-modified sample in Embodiment 1, there is almost no phase change layer on the surface of the primary grain.

### Performance tests:

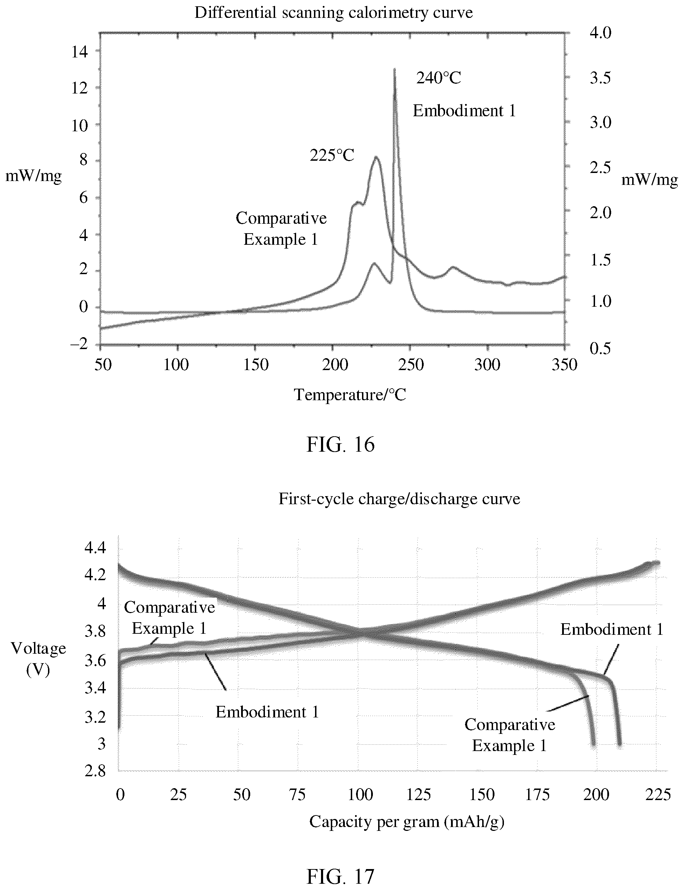

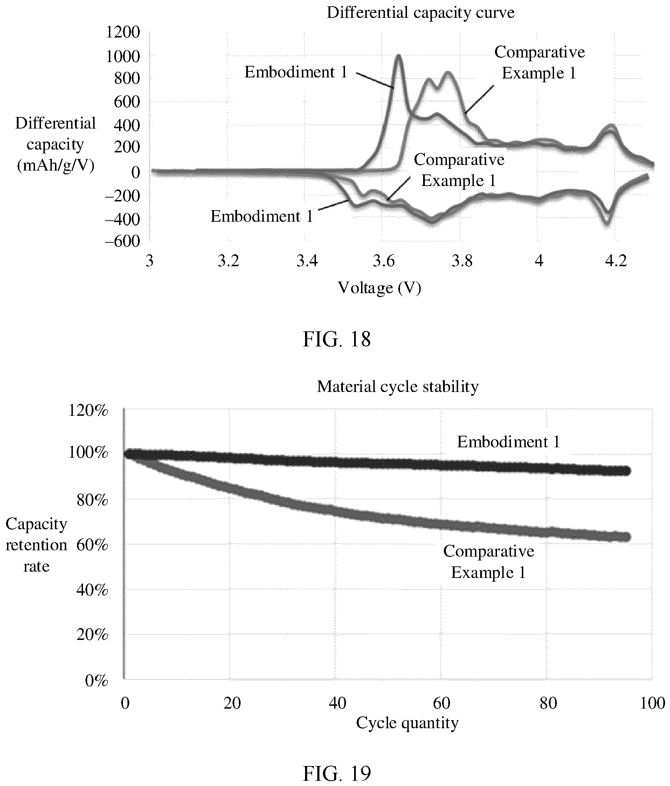

(1) Thermal stability test: Thermal stability evaluation is performed on the samples in Embodiment 1 and Comparative Example 1 through differential scanning calorimetry (DSC). Test temperature ranges from 25°C to 350°C. A specific evaluation method is as follows: At 25±5°C, a charge/discharge test is performed on each of the batteries in Embodiment 1 and Comparative Example 1 for one cycle at a charge/discharge rate of 0.1 C/0.1 C within a voltage range of 3.0 V to 4.3 V Then, the batteries are charged at 0.1 C to 4.3 V, and then charged at a constant voltage until a current is less than 0.025 C. The batteries are disassembled in a glove box. 3 mg to 5 mg of powder is scraped from a positive electrode and placed in a high-pressure crucible, 15 µL of electrolyte is dropwise added. Then, the crucible is covered by a gold-plated gasket and sealed. The scraped powder samples in Embodiment 1 and Comparative Example 1 are heated from 25°C to 350°C, to obtain differential scanning calorimetry (DSC) curves. FIG. 16 shows differential scanning calorimetry curves of the positive-electrode material samples in Embodiment 1 and Comparative Example 1. For Embodiment 1, refer to a vertical coordinate value on the left side of the figure. For Comparative Example 1, refer to a vertical coordinate value on a right side of the figure. It can be learned from FIG. 16 that, compared with the sample in Comparative Example 1, peak temperature of a DSC exothermic peak in Embodiment 1 increases from 225°C to 240°C. This indicates that thermal stability of the grain boundary-modified polycrystalline positive-electrode material LiNi_{0.82}Co_{0.12}Mn_{0.06}O₂ in Embodiment 1 is improved by 15°C. This is because a proportion of a length of a grain boundary at which a width of an intergranular gap is greater than or equal to 0.5 nm in the grain boundary-modified polycrystalline positive-electrode material LiNi_{0.82}Co_{0.12}Mn_{0.06}O₂ is greatly reduced, thereby reducing active sites for side reactions between the positive-electrode material and the electrolyte, suppressing a lattice oxygen escape, and improving the thermal stability of the material.
(2) Initial charge/discharge test: At 25±5°C, a charge/discharge test is performed on each of the batteries in Embodiment 1 and Comparative Example 1 for one cycle at a charge/discharge rate of 0.1 C/0.1 C within a voltage range of 3.0 V to 4.3 V Table 1 shows results of initial charge-discharge capacities and initial coulombic efficiency of the batteries in Embodiment 1 and Comparative Example 1. FIG. 17 shows initial charge/discharge curves of the batteries in Embodiment 1 and Comparative Example 1. FIG. 18 shows differential capacity curves of the batteries in Embodiment 1 and Comparative Example 1.

**Table 1: Electrochemical capacity, initial coulombic efficiency, and cycle stability of batteries in Embodiment 1 and Comparative Example 1**

| Sample | Charge specific capacity at 0.1C | Discharge specific capacity at 0.1C | Initial coulombic efficiency | Capacity retention rate after 95 cycles |
|---|---|---|---|---|
| Embodiment 1 | 222.5 mAh g⁻¹ | 209.4 mAh g⁻¹ | 94.1% | 92% |
| Comparative Example 1 | 228.8 mAh g⁻¹ | 200.2 mAh g⁻¹ | 87.5% | 62% |

It can be learned from Table 1, FIG. 17, and FIG. 18 that the battery in Embodiment 1 has significantly better initial coulombic efficiency and a better first-cycle discharge capacity than the battery in Comparative Example 1. It can be observed from the differential capacity curves that an oxidation peak of the grain boundary-modified polycrystalline positive-electrode material LiNi_{0.82}Co_{0.12}Mn_{0.06}O₂ is clearly left shifted. This indicates that kinetics characteristics of the material are significantly improved.
(3) Cycle performance test: At 25±5°C, a charge/discharge test is performed on each of the batteries in Embodiment 1 and Comparative Example 1 for 95 cycles at a charge/discharge rate of 1 C/1 C within a voltage range of 3.0 V to 4.3 V, and capacity retention rates are calculated. FIG. 19 shows cycle performance curves of the batteries in Embodiment 1 and Comparative Example 1 according to this application. It can be learned from FIG. 19 that, compared with the sample in Comparative Example 1, a capacity retention rate after 95 cycles of the battery in Embodiment 1 increases from 62% to 92%. In other words, the battery cycle performance of the grain boundary-modified polycrystalline positive-electrode material LiNi_{0.82}Co_{0.12}Mn_{0.06}O₂ is significantly improved compared with the material before modification.

### Embodiment 2

A lithium-rich manganese-based polycrystalline positive-electrode material Li[Li_{0.2}Mn_{0.54}Ni_{0.13}Co_{0.13}]O₂ of a lithium-ion battery is used as an example. Grain boundary modification includes the following specific steps:
(1) 1 kg of polycrystalline positive-electrode material Li[Li_{0.2}Mn_{0.54}Ni_{0.13}Co_{0.13}]O₂ was uniformly mixed with 5 mol% of lithium nitrate, to obtain a mixture.
(2) The mixture in (1) was heated to 500°C to melt lithium nitrate, kept at the same temperature for 3 hours, and was then cooled naturally to room temperature.
(3) Flow oxygen was introduced into the mixture obtained through the melting and impregnation in (2). The mixture was heated to 600°C, kept at the same temperature for 5 hours and then cooled naturally to room temperature, to obtain a grain boundary-modified polycrystalline positive-electrode material Li[Li_{0.2}Mn_{0.54}Ni_{0.13}Co_{0.13}]O₂.

It is obtained through detection that, in the cross section of the grain boundary-modified polycrystalline positive-electrode material Li[Li_{0.2}Mn_{0.54}Ni_{0.13}Co_{0.13}]O₂ in Embodiment 2, a ratio of a grain boundary length of a grain boundary at which a width of an intergranular gap is greater than or equal to 0.5 nm to a total grain boundary length is less than 0.4. A continuous length of a grain boundary at which a width of an intergranular gap is less than 0.5 nm is 10 nm to 1000 nm. A battery is assembled by using the method the same as that in Embodiment 1 and Comparative Example 1 for testing. It is learned from the test that, compared with unmodified polycrystalline positive-electrode material Li[Li_{0.2}Mn_{0.54}Ni_{0.13}Co_{0.13}]O₂, thermal stability, initial coulombic efficiency, and cycle performance of the grain boundary-modified polycrystalline positive-electrode material Li[Li_{0.2}Mn_{0.54}Ni_{0.13}Co_{0.13}]O₂ are significantly improved. The thermal stability of the material is improved by 15°C, and the initial coulombic efficiency is improved by 5%.

### Embodiment 3

A composite polycrystalline positive-electrode material LiNi_{0.82}Co_{0.12}Mn_{0.06}O₂/LiCoO₂ of a lithium-ion battery is used as an example. Grain boundary modification includes the following specific steps:
(1) 1 kg of monocrystalline positive-electrode material LiNi_{0.82}Co_{0.12}Mn_{0.06}O₂ and 1 kg of monocrystalline positive-electrode material LiCoO₂ were uniformly mixed with 5 mol% of lithium hydroxide, to obtain a mixture.
(2) The mixture in (1) was heated to 600°C to melt the lithium salt, kept at the same temperature for 5 hours, and was then cooled naturally to room temperature.
(3) Flow oxygen was introduced into the mixture obtained through the melting and impregnation in (2). The mixture was heated to 500°C, kept at the same temperature for 5 hours and then cooled naturally to room temperature, to obtain a grain boundary-modified composite polycrystalline positive-electrode material LiNi_{0.82}Co_{0.12}Mn_{0.06}O₂/LiCoO₂. The composite polycrystalline positive-electrode material includes both LiNi_{0.82}Co_{0.12}Mn_{0.06}O₂ monocrystalline grains and LiCoO₂ monocrystalline grains.

It is obtained through detection that, in the cross section of the grain boundary-modified composite polycrystalline positive-electrode material LiNi_{0.82}Co_{0.12}Mn_{0.06}O₂/LiCoO₂ in Embodiment 3, a ratio of a grain boundary length of a grain boundary at which a width of an intergranular gap is greater than or equal to 0.5 nm to a total grain boundary length is less than 0.2. A continuous length of a grain boundary at which a width of an intergranular gap is less than 0.5 nm is 10 nm to 1000 nm.

A battery is assembled by using the method the same as that in Embodiment 1 and Comparative Example 1 for testing. It is learned from the test that, compared with unmodified polycrystalline positive-electrode material LiNi_{0.82}Co_{0.12}Mn_{0.06}O₂/LiCoO₂ , thermal stability, initial coulombic efficiency, and cycle performance of the grain boundary-modified polycrystalline positive-electrode material LiNi_{0.82}Co_{0.12}Mn_{0.06}O₂/LiCoO₂ are significantly improved. The thermal stability of the material is improved by 20°C, and the initial coulombic efficiency is improved by 8%.

### Embodiment 4

A sodium-copper-iron-manganese oxide positive-electrode material Na_{0.9}Cu_{0.22}Co_{0.30}Mn_{0.48}O₂ of a sodium-ion battery is used as an example. Grain boundary modification includes the following specific steps:
(1) 1 kg of positive-electrode material Na_{0.9}Cu_{0.22}Co_{0.30}Mn_{0.48}O₂ was uniformly mixed with 5 mol% of sodium nitrate, to obtain a mixture.
(2) The mixture in (1) was heated to 260°C to melt the sodium salt, kept at the same temperature for 3 hours, and was then cooled naturally to room temperature.
(3) Flow oxygen was introduced into the mixture obtained through the melting and impregnation in (2). The mixture was heated to 500°C, kept at the same temperature for 5 hours and then cooled naturally to room temperature, to obtain a grain boundary-modified high-initial coulombic efficiency polycrystalline positive-electrode material Na_{0.9}Cu_{0.22}Co_{0.30}Mn_{0.48}O₂.

It is obtained through detection that, in the cross section of the grain boundary-modified polycrystalline positive-electrode material Na_{0.9}Cu_{0.22}Co_{0.30}Mn_{0.48}O₂ in Embodiment 4, a ratio of a grain boundary length of a grain boundary at which a width of an intergranular gap is greater than or equal to 0.5 nm to a total grain boundary length is less than 0.4. A continuous length of a grain boundary at which a width of an intergranular gap is less than 0.5 nm is 10 nm to 1000 nm.

Sodium-ion batteries are assembled respectively with the polycrystalline positive-electrode materials before and after modification in Embodiment 4 by using the same method for testing. It is learned from the test that, compared with the unmodified polycrystalline positive-electrode material Na_{0.9}Cu_{0.22}Co_{0.30}Mn_{0.48}O₂, thermal stability, initial coulombic efficiency, and cycle performance of the grain boundary-modified polycrystalline positive-electrode material Na_{0.9}Cu_{0.22}Co_{0.30}Mn_{0.48}O₂ are significantly improved. The thermal stability of the material is improved by 10°C, and the initial coulombic efficiency is improved by 5%.

### Embodiment 5

A solid-state electrolyte LiAlCl₄ of a lithium-ion battery is used as an example. Grain boundary modification includes the following specific steps:
(1) 1 kg of solid-state electrolyte LiAlCl₄ was uniformly mixed with 5 mol% of lithium chloride, to obtain a mixture.
(2) The mixture in (1) was heated to 300°C to melt the lithium salt, kept at the same temperature for 5 hours, and was then cooled naturally to room temperature.
(3) Flow argon was introduced into the mixture obtained through the melting and impregnation in (2). The mixture was heated to 450°C, kept at the same temperature for 5 hours and then cooled naturally to room temperature, to obtain a grain boundary-modified high-ionic conductivity solid-state electrolyte material LiAlCl₄.

It is obtained through detection that, in the cross section of the grain boundary-modified solid-state electrolyte LiAlCl₄ in Embodiment 5, a ratio of a grain boundary length of a grain boundary at which a width of an intergranular gap is greater than or equal to 0.5 nm to a total grain boundary length is less than 0.5. A continuous length of a grain boundary at which a width of an intergranular gap is less than 0.5 nm is 10 nm to 1000 nm. In Embodiment 5, the ionic conductivity of the grain boundary-modified solid-state electrolyte LiAlCl₄ is improved by 50% compared with the solid-state electrolyte material before modification.

### Embodiment 6

A magnesium-cobalt-manganese oxide positive-electrode material MgCo_{0.4}Mn_{1.6}O₄ of a magnesium-ion battery is used as an example. Grain boundary modification includes the following specific steps:
(1) 1 kg of positive-electrode material MgCo_{0.4}Mn_{1.6}O₄ was uniformly mixed with 5 mol% of magnesium nitrate, to obtain a mixture.
(2) The mixture in (1) was heated to 150°C to melt magnesium nitrate, kept at the same temperature for 3 hours, and was then cooled naturally to room temperature.
(3) Flow oxygen was introduced into the mixture obtained through the melting and impregnation in (2). The mixture was heated to 500°C, kept at the same temperature for 5 hours and then cooled naturally to room temperature, to obtain a grain boundary-modified high-initial coulombic efficiency polycrystalline positive-electrode material MgCo_{0.4}Mn_{1.6}O₄.

It is obtained through detection that, in the cross section of the grain boundary-modified polycrystalline positive-electrode material MgCo_{0.4}Mn_{1.6}O₄ in Embodiment 6, a ratio of a grain boundary length of a grain boundary at which a width of an intergranular gap is greater than or equal to 0.5 nm to a total grain boundary length is less than 0.4. A continuous length of a grain boundary at which a width of an intergranular gap is less than 0.5 nm is 10 nm to 1000 nm.

Magnesium-ion batteries are assembled respectively with the polycrystalline positive-electrode materials before and after modification in Embodiment 6 by using the same method for testing. It is learned from the test that, compared with the unmodified polycrystalline positive-electrode material MgCo_{0.4}Mn_{1.6}O₄, thermal stability, initial coulombic efficiency, and cycle performance of the grain boundary-modified polycrystalline positive-electrode material MgCo_{0.4}Mn_{1.6}O₄ are significantly improved. The thermal stability of the material is improved by 10°C, and the initial coulombic efficiency is improved by 6%.

### Embodiment 7

A polycrystalline positive-electrode material LiNi_{0.82}Co_{0.12}Mn_{0.06}O₂ of a lithium-ion battery is used as an example. Grain boundary modification with a lithium supplement Li₂C₂O₄ includes the following specific steps:
(1) 1 kg of positive-electrode material LiNi_{0.82}Co_{0.12}Mn_{0.06}O₂ was uniformly mixed with 1 mol% of Li₂C₂O₄, to obtain a mixture.
(2) The mixture in (1) was heated to 850°C to melt Li₂C₂O₄, kept at the same temperature for 8 hours, and then cooled naturally to room temperature, to obtain a grain boundary-modified polycrystalline positive-electrode material LiNi_{0.82}Co_{0.12}Mn_{0.06}O₂.

It is obtained through detection that the grain boundary of the grain boundary-modified polycrystalline positive-electrode material LiNi_{0.82}Co_{0.12}Mn_{0.06}O₂ in Embodiment 7 is filled with the lithium supplement Li₂C₂O₄, and in the cross section, a ratio of a grain boundary length of a grain boundary at which a width of an intergranular gap is greater than or equal to 1 nm to a total grain boundary length is less than 0.5. A continuous length of a grain boundary at which a width of an intergranular gap is less than 1 nm is 10 nm to 1000 nm.

Lithium-ion batteries are assembled respectively with the polycrystalline positive-electrode materials before and after modification in Embodiment 7 by using the same method for testing. It is learned from the test that, compared with the unmodified polycrystalline positive-electrode material LiNi_{0.82}Co_{0.12}Mn_{0.06}O₂, the polycrystalline positive-electrode material LiNi_{0.82}Co_{0.12}Mn_{0.06}O₂ with the grain boundary modified by Li₂C₂O₄ additionally releases an extra capacity of 10 mAh/g in a first-cycle charge process, and has thermal stability improved by 8°C and cycle performance significantly improved.

### Embodiment 8

A polycrystalline positive-electrode material LiNi_{0.82}Co_{0.12}Mn_{0.06}O₂ of a lithium-ion battery is used as an example. Grain boundary modification with a lithium supplement Li₂NiO₂ includes the following specific steps:
(1) 1 kg of positive-electrode material LiNi_{0.82}Co_{0.12}Mn_{0.06}O₂ was uniformly mixed with 1 mol% of Li₂NiO₂, to obtain a mixture.
(2) The mixture in (1) was heated to 550°C to melt Li₂NiO₂, kept at the same temperature for 8 hours, and then cooled naturally to room temperature, to obtain a grain boundary-modified polycrystalline positive-electrode material LiNi_{0.82}Co_{0.12}Mn_{0.06}O₂.

It is obtained through detection that the grain boundary of the grain boundary-modified polycrystalline positive-electrode material LiNi_{0.82}Co_{0.12}Mn_{0.06}O₂ in Embodiment 8 is filled with the lithium supplement Li₂NiO₂, and in the cross section, a ratio of a grain boundary length of a grain boundary at which a width of an intergranular gap is greater than or equal to 1 nm to a total grain boundary length is less than 0.5. A continuous length of a grain boundary at which a width of an intergranular gap is less than 1 nm is 10 nm to 1000 nm.

Lithium-ion batteries are assembled respectively with the polycrystalline positive-electrode materials before and after modification in Embodiment 8 by using the same method for testing. It is learned from the test that, compared with the unmodified polycrystalline positive-electrode material LiNi_{0.82}Co_{0.12}Mn_{0.06}O₂, the polycrystalline positive-electrode material LiNi_{0.82}Co_{0.12}Mn_{0.06}O₂ with the grain boundary modified by Li₂NiO₂ additionally releases an extra capacity of 10 mAh/g in a first-cycle charge process, and has thermal stability improved by 10°C and cycle performance significantly improved.

## Claims

1. A crystal material, wherein the crystal material comprises a secondary particle formed by agglomerating a plurality of monocrystalline grains, there are grain boundaries between the plurality of monocrystalline grains, and in a cross section of the secondary particle, a ratio L₃/L₄ of a grain boundary length L₃ of a grain boundary at which a width of an intergranular gap is greater than or equal to 2 nm to a total grain boundary length L₄ is less than or equal to 0.8; or
the crystal material comprises a monocrystalline particle, each monocrystalline particle comprises one monocrystalline grain, m monocrystalline particles comprise n first monocrystalline particles, a ratio n/m of n to m is greater than or equal to 0.5, and m ≥ 10; and in cross sections of the first monocrystalline particles, a ratio L₁/L₂ of a total length L₁ of all gaps whose widths are greater than or equal to 2 nm to a circumference L₂ of the cross sections is less than or equal to 0.45.

2. The crystal material according to claim 1, wherein in the cross section of the secondary particle, the ratio L₃/L₄ of the grain boundary length L₃ of the grain boundary at which the width of the intergranular gap is greater than or equal to 2 nm to the total grain boundary length L₄ is less than or equal to 0.5.

3. The crystal material according to claim 1, wherein in the cross section of the secondary particle, a ratio L₅/L₄ of a grain boundary length L₅ of a grain boundary at which a width of an intergranular gap is greater than or equal to 1.5 nm to the total grain boundary length L₄ is less than or equal to 0.8.

4. The crystal material according to claim 1, wherein in the cross section of the secondary particle, a ratio L₆/L₄ of a grain boundary length L₆ of a grain boundary at which a width of an intergranular gap is greater than or equal to 1 nm to the total grain boundary length L₄ is less than or equal to 0.8.

5. The crystal material according to claim 1, wherein in the cross section of the secondary particle, a ratio L₇/L₄ of a grain boundary length L₇ of a grain boundary at which a width of an intergranular gap is greater than or equal to 0.5 nm to the total grain boundary length L₄ is less than or equal to 0.8.

6. The crystal material according to any one of claims 1 to 5, wherein in the cross section of the secondary particle, a continuous grain boundary length of a grain boundary at which a width of an intergranular gap is less than 2 nm is 10 nm to 1000 nm.

7. The crystal material according to any one of claims 1 to 6, wherein in the secondary particle, there is no impurity element, different from each element in adjacent monocrystalline grains, at a grain boundary between the adjacent monocrystalline grains.

8. The crystal material according to claim 7, wherein the grain boundary between the adjacent monocrystalline grains is a crystal structure obtained through epitaxial growth along atomic arrangements of the adjacent monocrystalline grains.

9. The crystal material according to claim 7, wherein the grain boundary between the adjacent monocrystalline grains is filled with a first metal salt, and the first metal salt is an alkali metal salt or an alkaline earth metal salt that has a same alkali metal or alkaline earth metal element as the adjacent monocrystalline grains.

10. The crystal material according to any one of claims 1 to 6, wherein in the secondary particle, there is an impurity element, different from each element in adjacent monocrystalline grains, at a grain boundary between the adjacent monocrystalline grains.

11. The crystal material according to claim 10, wherein the grain boundary between the adjacent monocrystalline grains is filled with a second metal salt, and the second metal salt is an alkali metal salt or an alkaline earth metal salt that has a same alkali metal or alkaline earth metal element as the adjacent monocrystalline grains.

12. The crystal material according to any one of claims 1 to 11, wherein a thickness of a phase change layer on a surface of the monocrystalline grain is less than or equal to 1 nm.

13. The crystal material according to any one of claims 1 to 12, wherein in the secondary particle, crystal face orientations of two adjacent monocrystalline grains are random.

14. The crystal material according to any one of claims 1 to 13, wherein in the secondary particle, at least some adjacent monocrystalline grains are fused at a grain boundary to form a grain boundary-modified agglomerate, each grain boundary-modified agglomerate comprises two or more monocrystalline grains, and in the grain boundary-modified agglomerate, a width of an intergranular gap at a grain boundary at which monocrystalline grains are fused is less than 2 nm.

15. The crystal material according to claim 14, wherein fusion of the at least some adjacent monocrystalline grains at the grain boundary is atomic-level epitaxial junction fusion, and the width of the intergranular gap at the grain boundary is less than or equal to 0.5 nm.

16. The crystal material according to any one of claims 1 to 15, wherein the monocrystalline grain is a battery electrode material or a solid-state electrolyte.

17. The crystal material according to claim 16, wherein the battery electrode material comprises a lithium-ion battery electrode material, a sodium-ion battery electrode material, a potassium-ion battery electrode material, or a magnesium-ion battery electrode material.

18. The crystal material according to claim 17, wherein the lithium-ion battery electrode material comprises a lithium-containing composite oxide; the sodium-ion battery electrode material comprises one or more of a sodium-containing composite oxide, Prussian blue, and Prussian white; the potassium-ion battery electrode material comprises a potassium-containing composite oxide; and the magnesium-ion battery electrode material comprises a magnesium-containing composite oxide.

19. The crystal material according to claim 16, wherein the solid-state electrolyte comprises one or more of an oxide-type solid-state electrolyte, a sulfide-type solid-state electrolyte, and a halogenated solid-state electrolyte.

20. A crystal material, wherein the crystal material comprises a monocrystalline particle, and each monocrystalline particle comprises one monocrystalline grain; or the crystal material comprises a secondary particle formed by agglomerating a plurality of monocrystalline grains, wherein a thickness of a phase change layer on a surface of the monocrystalline grain is less than or equal to 1 nm.

21. The crystal material according to claim 20, wherein m monocrystalline particles comprise n first monocrystalline particles, a ratio n/m of n to m is greater than or equal to 0.5, and m ≥ 10; and in cross sections of the first monocrystalline particles, a ratio L₁/L₂ of a total length L₁ of all gaps whose widths are greater than or equal to 2 nm to a circumference L₂ of the cross sections is less than or equal to 0.45.

22. The crystal material according to claim 20, wherein there are grain boundaries between the plurality of monocrystalline grains, and in a cross section of the secondary particle, a ratio L₃/L₄ of a grain boundary length L₃ of a grain boundary at which a width of an intergranular gap is greater than or equal to 2 nm to a total grain boundary length L₄ is less than or equal to 0.8.

23. The crystal material according to claim 22, wherein in the cross section of the secondary particle, a continuous grain boundary length of a grain boundary at which a width of an intergranular gap is less than 2 nm is 10 nm to 1000 nm.

24. The crystal material according to any one of claims 20 to 23, wherein in the secondary particle, there is no impurity element, different from each element in adjacent monocrystalline grains, at a grain boundary between the adjacent monocrystalline grains.

25. The crystal material according to claim 24, wherein the grain boundary between the adjacent monocrystalline grains is a crystal structure obtained through epitaxial growth along atomic arrangements of the adjacent monocrystalline grains; or the grain boundary between the adjacent monocrystalline grains is filled with a first metal salt, and the first metal salt is an alkali metal salt or an alkaline earth metal salt that has a same alkali metal or alkaline earth metal element as the adjacent monocrystalline grains.

26. The crystal material according to any one of claims 20 to 23, wherein in the secondary particle, there is an impurity element, different from each element in adjacent monocrystalline grains, at a grain boundary between the adjacent monocrystalline grains.

27. The crystal material according to claim 26, wherein the grain boundary between the adjacent monocrystalline grains is filled with a second metal salt, and the second metal salt is an alkali metal salt or an alkaline earth metal salt that has a same alkali metal or alkaline earth metal element as the adjacent monocrystalline grains.

28. The crystal material according to any one of claims 20 to 27, wherein the monocrystalline grain is a battery electrode material or a solid-state electrolyte.

29. A method for preparing a crystal material, comprising the following steps:
mixing a to-be-modified crystal material primary product with a metal salt to obtain a mixture, heating the mixture to melt the metal salt, and then cooling the mixture, wherein a metal element of the metal salt is an alkali metal element or an alkaline earth metal element that is the same as that of the crystal material primary product; and
collecting the cooled mixture to obtain the crystal material; or introducing oxygen or inert gas into the cooled mixture, and heating to 400°C to 900°C and keeping at the same temperature for 1 hour to 12 hours, to obtain the crystal material.

30. The preparation method according to claim 29, wherein a molar mass of the metal salt is 0.1% to 20% of a molar mass of the crystal material primary product.

31. The preparation method according to claim 29 or 30, wherein the alkali metal element comprises one or more of a lithium element, a sodium element, and a potassium element; the alkaline earth metal element comprises a magnesium element; when the crystal material primary product comprises the lithium element, the metal salt comprises a lithium salt; when the crystal material primary product comprises the sodium element, the metal salt comprises a sodium salt; when the crystal material primary product comprises the potassium element, the metal salt comprises a potassium salt; and when the crystal material primary product comprises the magnesium element, the metal salt comprises a magnesium salt.

32. The preparation method according to claim 31, wherein the lithium salt comprises one or more of lithium nitrate, lithium hydroxide, lithium carbonate, and a lithium supplement; and the sodium salt comprises one or more of sodium nitrate, sodium hydroxide, sodium carbonate, and a sodium supplement.

33. A battery, wherein the battery comprises the crystal material according to any one of claims 1 to 19, or the crystal material according to any one of claims 20 to 28, or the crystal material obtained by using the preparation method according to any one of claims 29 to 32.

34. An electronic device, wherein the electronic device comprises the battery according to claim 33.

35. An energy storage system, wherein the energy storage system comprises the battery according to claim 33.
